# EUROPEAN PATENT SPECIFICATION

(11) **EP 3 494 550 B1**
(45) Date of publication and mention of the grant of the patent: **06.10.2021**
(21) Application number: 17742273.0
(22) Date of filing: 12.07.2017
(51) Int. Cl.: G06T 19/20, A63F 13/85, G06T 7/00, B33Y 50/00, A63F 13/25, A63F 13/52, B29C 64/386

(54) **DEVICE AND METHOD OF ANALYSING AN OBJECT FOR 3D PRINTING**
VERFAHREN UND VORRICHTUNG ZUR ANALYSE EINES OBJEKTS ZUM 3D-DRUCKEN
PROCÉDÉ ET APPAREIL POUR ANALYSER UN OBJET POUR IMPRESSION 3D

(30) Priority: 04.08.2016 GB 201613472
(43) Date of publication of application: 12.06.2019
(73) Proprietor: Sony Interactive Entertainment Inc., Tokyo 108-0075 (JP); Sony Interactive Entertainment Europe Limited, London W1F 7LP (GB)
(72) Inventor: BIGOS, Andrew James, London W1F 7LP (GB); NAGAI, Norihiro, Tokyo 108-0075 (JP); SUZUOKI, Masakazu, Tokyo 108-0075 (JP); ROBERTS, Jean-Paul, London W1F 7LP (GB)
(74) Representative: D Young & Co LLP
(86) International application number: PCT/GB2017/052038
(87) International publication number: WO 2018/025009

(56) References cited:
- GB-A- 2 499 694
- US-A1- 2013 297 059
- Roxy: "7 Essential Tricks to Prepare Your 3D Model for 3D Printing", , 21 August 2014 (2014-08-21), XP055286238, Retrieved from the Internet: URL:https://i.materialise.com/blog/the-pri ntable-3d-design-checklist-common-design-f laws-and-how-to-fix-them/ [retrieved on 2016-07-06]
- Jenny Cheng: "3D printed ArcheAge", Caret Dash Caret, 15 September 2014 (2014-09-15), pages 1-3, XP055285839, Retrieved from the Internet: URL:https://caretdashcaret.com/2014/09/15/ 3d-printed-archeage/ [retrieved on 2016-07-05]
- Alec Buren: "Extract & 3D print models from your favorite video games", , 16 October 2014 (2014-10-16), pages 1-9, XP055299507, Retrieved from the Internet: URL:http://www.3ders.org/articles/20141016 -extracting-3d-printing-models-from-your-f avorite-video-games.html [retrieved on 2016-09-02]

## Description

The present invention relates to a device and method of analysing an object for 3D printing.

3D printing is a means of volumetric printing, where instead of depositing two-dimensional pixels on a flat surface, the printer deposits three-dimensional voxels within a volume. There are numerous technologies to achieve this, including the use of lasers to melt and fuse materials such as metal powder in incremental layers to build a structure, or the use of a high-temperature print-head to deposit small droplets of plastic that cool and harden to build up a 3D model.

The design for such a 3D model is typically generated in a computer-aided design program, in which a user defines surfaces and volumes of a virtual model. A drawing list is then generated by the program specifying the order in which to fuse or deposit materials to render the virtual model using the 3D printer.

This approach has resulted in the creation of many aesthetically and functionally unique objects, some of which are difficult to make using conventional processes. However the utility of 3D printers has still not been fully explored.

In particular, it may be desirable to capture dynamically generated or animated 3D models, such as those found in videogames, at a particularly memorable or significant point in time during gameplay.

However, this poses the problem that the model may be in an arbitrary pose at the selected moment, making successful 3D printing of the model difficult.

The present invention aims to address or mitigate this problem.

Other previously proposed arrangements are disclosed in US 2013/297059.

In a first aspect, a method of analysing an object from a videogame for 3D printing is provided according to claim 1.

In another aspect, a 3D printing analyser is provided according to claim 13.

Further respective aspects and features of the invention are defined in the appended claims.

Embodiments of the present invention will now be described by way of example with reference to the accompanying drawings, in which:
- Figure 1 is a schematic diagram of an entertainment device in accordance with embodiments of the present invention.
- Figure 2A is schematic diagram of a side elevation of a 3D printer in accordance with embodiments of the present invention.
- Figure 2B is schematic diagram of a plan view of a 3D printer in accordance with embodiments of the present invention.
- Figure 3A is a schematic diagram of a videogame virtual environment in accordance with embodiments of the present invention.
- Figure 3B is a schematic diagram of a videogame character model for 3D printing in accordance with embodiments of the present invention.
- Figure 4 is a schematic diagram of a projection in to a 3D model space in accordance with embodiments of the present invention.
- Figures 5A-E are schematic diagrams illustrating a process of generating geometry for 3D printing in accordance with embodiments of the present invention.
- Figure 6 is a schematic diagram of a 3D printable videogame character in accordance with embodiments of the present invention.
- Figure 7 is a schematic diagram of a 3D printable videogame character in accordance with embodiments of the present invention.
- Figure 8 is a flow diagram of a method of 3D printing a virtual environment in accordance with the present invention.
- Figures 9A-9C are schematic diagrams illustrating different arrangements and dependencies of in-game object elements in accordance with embodiments of the present invention.
- Figure 10 is a flow diagram of a method of analysing an object from a videogame for 3D printing in accordance with embodiments of the present invention.

A device and method of analysing an object from a videogame for 3D printing are disclosed. In the following description, a number of specific details are presented in order to provide a thorough understanding of the embodiments of the present invention. It will be apparent, however, to a person skilled in the art that these specific details need not be employed to practice the present invention. Conversely, specific details known to the person skilled in the art are omitted for the purposes of clarity where appropriate.

In an embodiment of the present invention, an entertainment device is operably coupled to a 3D printer. The entertainment device is arranged in operation to capture snapshots of videogame play for replication by the 3D printer, as explained later herein.

### Entertainment device

An example of a suitable entertainment device is the Sony® Playstation 4®.

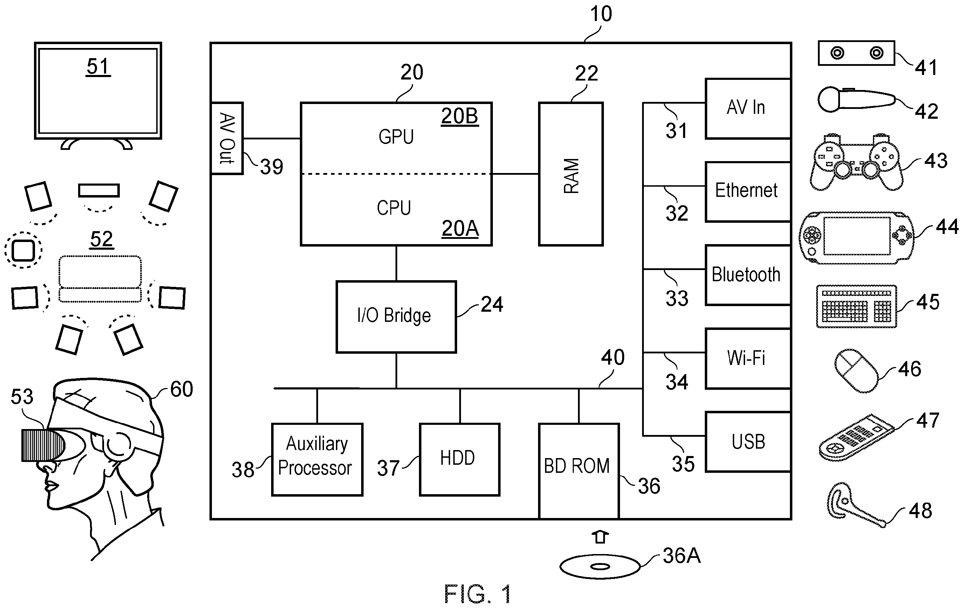

Figure 1 schematically illustrates the overall system architecture of the Sony® PlayStation 4® entertainment device. A system unit 10 is provided, with various peripheral devices connectable to the system unit.

The system unit 10 comprises an accelerated processing unit (APU) 20 being a single chip that in turn comprises a central processing unit (CPU) 20A and a graphics processing unit (GPU) 20B. The APU 20 has access to a random access memory (RAM) unit 22.

The APU 20 communicates with a bus 40, optionally via an I/O bridge 24, which may be a discreet component or part of the APU 20.

Connected to the bus 40 are data storage components such as a hard disk drive 37, and a Blu-ray ® drive 36 operable to access data on compatible optical discs 36A. Additionally the RAM unit 22 may communicate with the bus 40.

Optionally also connected to the bus 40 is an auxiliary processor 38. The auxiliary processor 38 may be provided to run or support the operating system.

The system unit 10 communicates with peripheral devices as appropriate via an audio/visual input port 31, an Ethernet ® port 32, a Bluetooth ® wireless link 33, a Wi-Fi ® wireless link 34, or one or more universal serial bus (USB) ports 35. Audio and video may be output via an AV output 39, such as an HDMI port.

The peripheral devices may include a monoscopic or stereoscopic video camera 41 such as the PlayStation Eye ® or PS Camera ®; wand-style videogame controllers 42 such as the PlayStation Move ® and conventional handheld videogame controllers 43 such as the DualShock 4 ®; portable entertainment devices 44 such as the PlayStation Portable ® and PlayStation Vita ®; a keyboard 45 and/or a mouse 46; a media controller 47, for example in the form of a remote control; and a headset 48. Other peripheral devices may similarly be considered such as a phone or tablet, printer, or a 3D printer (not shown).

The GPU 20B, optionally in conjunction with the CPU 20A, generates video images and audio for output via the AV output 39. Optionally the audio may be generated in conjunction with or instead by an audio processor (not shown).

The video and optionally the audio may be presented to a television 51. Where supported by the television, the video may be stereoscopic. The audio may be presented to a home cinema system 52 in one of a number of formats such as stereo, 5.1 surround sound or 7.1 surround sound. Video and audio may likewise be presented to a head mounted display unit 53 worn by a user 60. The head mounted display unit may have integral headphones, attachable headphones / earbuds, or rely on separate audio being supplied to the user.

In more detail, regarding processing, the CPU 20A may comprise two 64-bit quad core modules, based for example on the 'Jaguar' CPU architecture by AMD ®, for a total of eight cores. Each core may use a base clock speed of 1.6 GHz. The GPU 20B may comprise 18 compute units each comprising 64 cores, for a total of 1152 cores. The GPU may be based for example on the Radeon ® GCN architecture by AMD ®. The GPU cores may be used for graphics, physics calculations, and/or general-purpose processing.

Regarding storage, the system RAM 22 may comprise 8GB RAM, for example in 16 blocks of 512MB GDDR5 unified system memory, and is shared by the CPU and GPU. Meanwhile the hard disk may be a 500 GB hard drive. Optionally the hard drive is mounted so as to be replaceable by a user of the system unit. The Blu-ray ® drive may read data from Blu-ray discs at multiples of the standard reading speed. The Blu-ray drive may be operably coupled to a hardware-implemented so-called 'zlib' decompression module. The auxiliary processor may be provided with its own local memory, such as for example 256 MB of DDR3 SDRAM.

Regarding communication, the system unit 10 may comprise 802.11 b/g/n Wi-Fi® 34; 10Base-T, 100BASE-TX and 1000BASE-T Ethernet ® 32; Bluetooth 2.1 ® 33 and one or more USB 3.0 ports 35. The system unit may receive video and optionally audio via AV input 31. Similarly the system unit may output video and optionally audio via AV output 39 or via Bluetooth ®, Wi-Fi ® or USB.

Regarding peripherals, the system unit is typically provided with at least one hand-held controller 43 such as the DualShock 4 ®. This controller may be used to interact with user interfaces presented by the system unit that are associated with the operating system and/or a particular game or application being run by the system unit.

The user may also interact with the system unit using a video camera 41 such as the PlayStation Eye ®. This may provide monoscopic or stereoscopic video images to the system unit 10 via for example AV input 31. Where these images capture some or all of the user, the user may enact gestures, facial expressions or speech as appropriate to interact with the currently presented user interface.

Alternatively or in addition, a controller designed to assist with camera-based user interaction, such as the PlayStation Move ® 42, may be provided. This controller has a wand form factor and an illuminated region that facilitates detection of the controller within a captured video image. Illuminated regions may similarly be provided on other controllers 43, such as on the DualShock 4 ®. Both kinds of controller comprise motion sensors to detect transverse movement along three axes and rotational movement around three axes, and wireless communication means (such as Bluetooth®) to convey movement data to the system unit. Optionally such controls can also receive control data from the system unit to enact functions such as a rumble effect, or to change the colour or brightness of the illuminated region, where these are supported by the controller.

The system unit may also communicate with a portable entertainment device 44. The portable entertainment device 44 will comprise its own set of control inputs and audio/visual outputs. Consequently, in a 'remote play' mode some or all of the portable entertainment device's inputs may be relayed as inputs to the system unit 10, whilst video and/or audio outputs from the system unit 10 may be relayed to the portable entertainment device for use with its own audio/visual outputs. Communication may be wireless (e.g. via Bluetooth ® or Wi-Fi ®) or via a USB cable.

Other peripherals that may interact with the system unit 10, via either wired or wireless means, include a keyboard 45, a mouse 46, a media controller 47, and a headset 48. The headset may comprise one or two speakers, and optionally a microphone.

Regarding output, the GPU typically generates a 1080p high definition image to the AV output 39. The frame rate of these images may vary. The image is typically conveyed to a television 51 via a standard HDMI connection, optionally via an AV receiver (not shown). Where the television supports stereoscopic display, and optionally in response to a command from the user, the 1080p high definition may be formatted as a stereoscopic image for example using a left-right side-by-side format. The television will then split the image in two and interpolate each half to full width for respective presentation to the user's left and right eyes, either by use of specially adapted glasses or by use of directed light paths from an autostereoscopic display.

Optionally in conjunction with an auxiliary audio processor (not shown), the APU 20 generates audio for output via the AV output 39. The audio signal is typically in a stereo format or one of several surround sound formats. Again this is typically conveyed to the television 51 via an HDMI standard connection. Alternatively or in addition, it may be conveyed to an AV receiver (not shown), which decodes the audio signal format and presented to a home cinema system 52. Audio may also be provided via wireless link to the headset 48 or to the hand-held controller 43. The hand held controller may then provide an audio jack to enable headphones or a headset to be connected to it.

Finally, the video and optionally audio may be conveyed to a head mounted display 53 such as the Sony Morpheus ® display. The head mounted display typically comprises two small display units respectively mounted in front of the user's eyes, optionally in conjunction with suitable optics to enable the user to focus on the display units. Alternatively one or more display sources may be mounted to the side of the user's head and operably coupled to a light guide to respectively present the or each displayed image to the user's eyes. Alternatively, one or more display sources may be mounted above the user's eyes and presented to the user via mirrors or half mirrors. In this latter case the display source may be a mobile phone or portable entertainment device 44, optionally displaying a split screen output with left and right portions of the screen displaying respective imagery for the left and right eyes of the user. Their head mounted display may comprise integrated headphones, or provide connectivity to headphones. Similarly the mounted display may comprise an integrated microphone or provide connectivity to a microphone.

In operation, the entertainment device defaults to an operating system such as Orbis OS ®, a variant of FreeBSD 9.0. The operating system may run on the CPU 20A, the auxiliary processor 38, or a mixture of the two. The operating system provides the user with a graphical user interface such as the PlayStation Dynamic Menu. The menu allows the user to access operating system features and to select games and optionally other content.

Upon start-up, respective users are asked to select their respective accounts using their respective controllers, so that optionally in-game achievements can be subsequently accredited to the correct users. New users can set up a new account. Users with an account primarily associated with a different entertainment device can use that account in a guest mode on the current entertainment device.

Once at least a first user account has been selected, the OS may provide a welcome screen displaying information about new games or other media, and recently posted activities by friends associated with the first user account.

The OS then provides a series of icons for the user to select amongst, for example in the form of two parallel horizontal rows. In this example the content of the top row may be fixed and relate to operating system features, whilst the bottom row may be at least in part dynamically assembled to relate to recent activities, such as providing launch icons for the most recently played or downloaded games.

The top row of icons may provide access to screens relating to an online store; notifications; friends; text chat; voice chat; user account profile; trophies; system settings; and/or power management.

When selected, the online store may provide access to games and media for download to the entertainment device. A welcome screen may highlight featured content. Where an online subscription service is provided (Such as so-called 'PS Plus'), then content or prices exclusive to that service may be provided in addition to standard content or prices. The store may also provide means to pay money into an online account for purchasing content, and may provide a record of purchases, enabling a user to download a purchased item of content at a later date or multiple times (for example after choosing to swap to a larger hard disk).

The notifications screen provides information about new trophies; game alerts (for example relating to special online events); game invites from friends; download and/or update status for content, and upload status for content being shared.

The friends screen allows a user to view all their friends or filter them according to who is currently online; additionally a user can review a list of other users they have met within games or other multi-user applications of the entertainment device, and optionally send such a user a friend request or conversely block a user to avoid encountering them again. In addition, optionally a user can request that a friend allow them to see their real name; subsequently they can also contact this friend via other social media such as Facebook®, optionally via a built-in interface.

Text chat provides a means to send messages to friends and other users of the entertainment device's network. Meanwhile voice chat provides a means to invite a group of friends to share an audio channel over the entertainment device's network so that they can chat to each other, for example whilst playing a game.

The account user profile screen allows a user to review statistics relating to their activities with the entertainment device. The screen also provides means to configure the user's appearance on the network, such as selecting an avatar to be associated with their username.

The trophy screen allows a user to view their trophies and in-game progress; trophies may be organised on a game-by-game basis. A user's trophies or other performance statistics may be compared with those of their friends to identify the friend with the closest better performance statistic in a game, so as to encourage the user to play further or improve their play of the game.

The system settings screen provides access to further menus enabling the user to configure aspects of the operating system. These include setting up an entertainment device network account, and network settings for wired or wireless communication with the Internet; the ability to select which notification types the user will receive elsewhere within the user interface; login preferences such as nominating a primary account to automatically log into on start-up, or the use of face recognition to select a user account where the video camera 41 is connected to the entertainment device; parental controls, for example to set a maximum playing time and/or an age rating for particular user accounts; save data management to determine where data such as saved games is stored, so that gameplay can be kept local to the device or stored either in cloud storage or on a USB to enable game progress to be transferred between entertainment devices; system storage management to enable the user to determine how their hard disk is being used by games and hence decide whether or not a game should be deleted; software update management to select whether or not updates should be automatic; audio and video settings to provide manual input regarding screen resolution or audio format where these cannot be automatically detected; connection settings for any companion applications run on other devices such as mobile phones; and connection settings for any portable entertainment device 44, for example to pair such a device with the entertainment device so that it can be treated as an input controller and an output display for so-called 'remote play' functionality.

The entertainment device network account may be set up to include the user's real name and optionally other personal details, bank details for online payments, an indication of whether the current entertainment device is the primary entertainment device associated with the user account, and the ability to selectively transfer licenses between entertainment devices where the user account is associated. Additionally a user may provide user account information for other services for which access may be integrated into the operating system, such as Facebook® and Twitter®; this enables easy sharing of the user's activities with friends who may not be on the entertainment device network but are on other social networks.

The power management icon allows the user to turn the device off. Optionally it may provide a timer for the entertainment device to turn off within a after a predetermined time unless the user intervenes.

The bottom row of the menu may show icons for recently played games, enabling quick access. Optionally selection of a game icon provides a summary of game progress and any relevant statistics, and where appropriate information such as progress and commentary from friends who have also played or are playing the game. Other information regarding the game may also be provided such as details of recently applied updates, or links to downloadable content associated with the game that is available in the online store.

The bottom row may also provide access to other media sources such as a web browser, television and music media applications, and any live streaming service provided by the entertainment device network. Additionally an icon may be provided to access the full library of content on the device, such as games that have not been recently played.

The user interface of the operating system may also receive inputs from specific controls provided on peripherals, such as the hand-held controller 43. In particular, a button to switch between a currently played game and the operating system interface may be provided. Additionally a button may be provided to enable sharing of the player's activities with others; this may include taking a screenshot or recording video of the current display, optionally together with audio from a user's headset. Such recordings may be uploaded to social media hubs such as the entertainment device network, Twitch®, Facebook® and Twitter®.

### 3D Printer

As was noted previously, the entertainment device is operably coupled to a 3D printer.

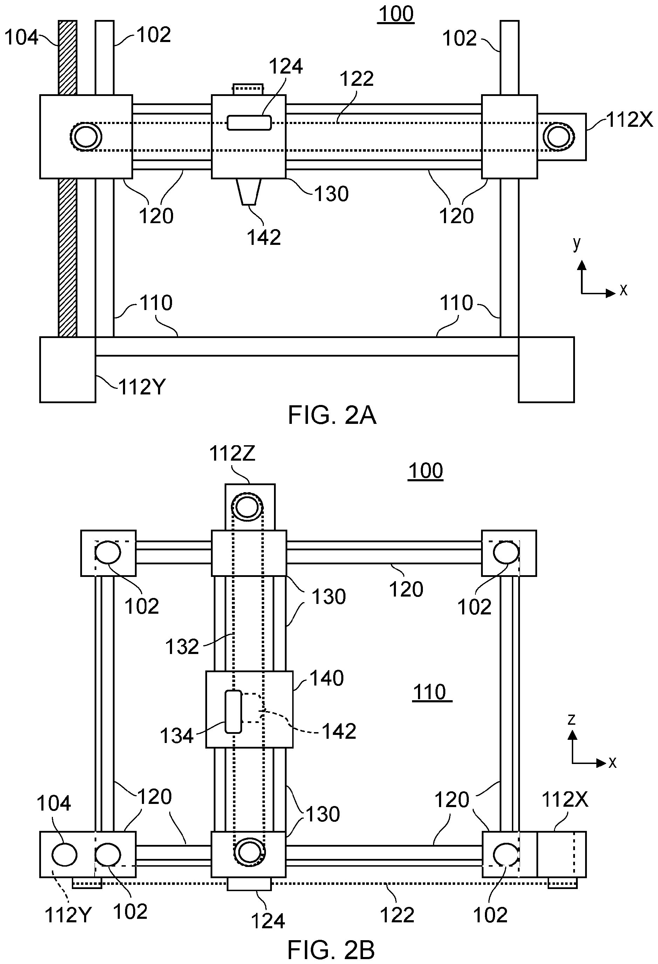

It will be appreciated that there are numerous technologies for 3D printing that are typically differentiated by how layers are built up to create a model. One technology is known as selective laser sintering (SLS), where a layer of powder is selectively fused together by a laser to create solid regions; a new layer of powder is then placed on top and the process repeats to build the model. Another technology is known as stereolithography, and uses a photo-reactive liquid in conjunction with one or more lasers to harden the liquid at defined points, thereby building the model, again typically in layers. Whilst both of these techniques are envisaged within the scope of embodiments of the present invention, they have the disadvantage of requiring both powerful lasers and large volumes of matrix material in the form of powder or liquid around the model, which make them less practical for domestic use. Consequently a preferred (but non-limiting) technology is fused deposition modelling (FDM). This approach melts plastic in a printer head that moves over successive layers of the model, depositing droplets of plastic at selective positions in each layer in a manner similar to the deposition of droplets of ink by an inkjet printer on a sheet of paper. This avoids the need for lasers or a surrounding matrix of the raw material used by the model. Accordingly for the purposes of understanding an FDM 3D printer is briefly described herein with reference to Figures 2A and 2B.

Figure 2A shows a side elevation of a simple FDM 3D printer 100, whilst Figure 2B shows a plan view of the same FDM 3D printer. The printer 100 comprises a base structure 110 that provides a working surface for assembly of the printed model and support struts 102 upon which a printer frame 120 can be raised and lowered.

In an example mechanism, a motor 112Y is coupled to a drive bar 104 comprising a screw thread; a printer frame 120 then comprises a coupling section with a threaded hole and a smooth hole, the threaded hole being engaged with the drive bar and the smooth hole being engaged with one of the support struts. When, under instruction from a printer driver, the motor 112Y turns the drive bar in a clockwise or anticlockwise direction, the printer frame is moved up or down the drive bar and support strut (i.e. along the y-axis) and hence raises or lowers a printer carriage 130 attached to it.

As can be seen from Figure 2B, the printer frame 120 is typically mounted on four support struts 102. Optionally a second motor, drive bar and coupling section may be provided at an opposing corner of the frame, to reduce strain on the frame and the motor.

The printer frame 120 supports the printer carriage 130. A motor 112X is coupled to a drive band 122 that is fixed by fixing means 124 to the printer carriage 130. When, under instruction from a printer driver, the motor 112X rotates the drive band clockwise or anticlockwise, the printer carriage 130 is moved right or left along the printer frame 120 (i.e. along the x-axis) and hence moves an attached printer mechanism 140 laterally.

The printer carriage 130 supports the printer mechanism 140. A motor 112Z is coupled to a drive band 132 that is fixed by fixing means 134 to the printer mechanism 140. When, under instruction from a printer driver, the motor 112Z rotates the drive band clockwise or anticlockwise, the printer mechanism 140 is moved in or out of a depth direction (i.e. along the z-axis).

The printer mechanism 140 itself comprises heating means for heating the end of one or more plastic threads fed into the mechanism (not shown), or for heating grains of plastic powder obtained from a hopper on the mechanism (not shown). The heating of the plastic or alternatively the release of heated plastic is controlled by instruction from a printer driver. A resulting bead or droplet of melted plastic is then deposited onto the working surface 110 of the printer or a partially built model (not shown) as applicable, through the printer head or nozzle 142.

In this way, under suitable instruction from a printer driver, the printer head can be positioned anywhere within a working volume of the 3D printer using motors 112X, Y, Z, and a droplet of plastic can be deposited at that position, which then cools and hardens to form a voxel of a 3D model. Through successive movement of the printer head and selective melting or release of plastic droplets, a completed 3D model can thus be built from a plurality of such voxels.

Typically the printer driver itself is a software module in a computer-aided design system that receives model geometry describing the 3D model. The printer driver then generates thin slices of the 3D model one voxel thick for each layer in the y direction, and determines the x, z coordinates for each voxel in that layer. The printer driver then outputs a sequence of instructions to the printer 100 to move the printer head 142 to the respective x, z coordinate for each voxel in layer y, where the printer mechanism is instructed to heat and/or release a droplet of plastic to form a voxel at that position. In this way the digital 3D model is rebuilt as a physical model by the 3D printer.

In an embodiment of the present invention, the printer driver is incorporated into the videogame, or the operating system of the entertainment device, or a middleware library of support functions used by either the videogame or the operating system.

### Virtual Environment

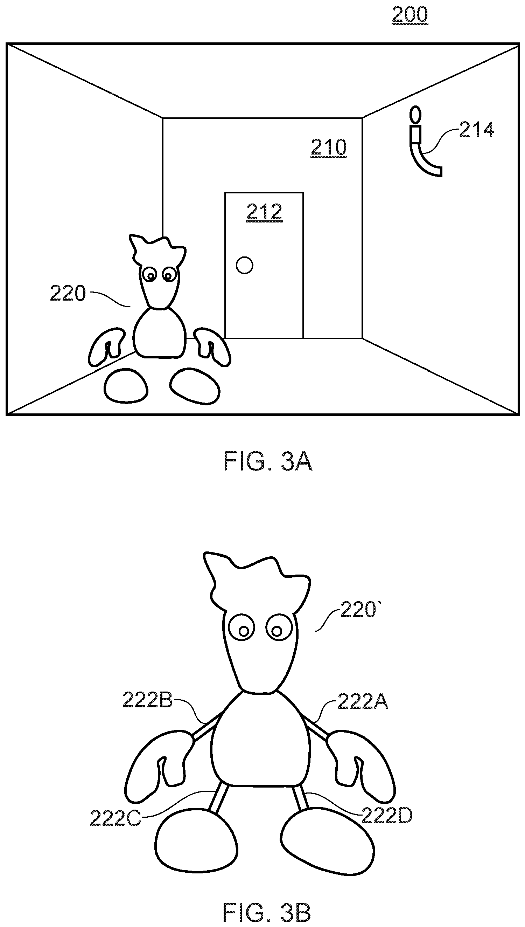

Referring now to Figure 3, a videogame running on the entertainment device comprises a virtual environment in which typically a plurality of entities or environmental elements are dynamically viewed as the user changes the position of viewpoint and as entities or elements of the game enact scripted activities, obey in-game laws of physics, react to the user's behaviour, or any mixture of these.

In Figure 3, a simple environment 200 is illustrated comprising a room 210 with a door 212; on one wall there is mounted a candle in a candleholder 214. In the room is the player's character 220 (here illustrated for example by the fictitious game character Blobman).

The virtual environment is constructed in 3D from geometry data, typically in the form of polygons defining a surface of an object. These polygons may be predefined for example in the case of static objects and background scenery, or may be warped/repositioned or procedurally generated in the case of mobile entities within the environment such as the player's character. It will be appreciated that references herein to 'polygons' encompasses preliminary geometrical features such as vertices, from which polygons are built, where these are used in the graphics pipeline. Similarly, voxel rendering uses equivalent geometric features to describe objects. Hence processes described as applying to polygons may be applied in whole or part to such other geometrical features as appropriate.

The virtual environment is then prepared for presentation to the user from a selected viewpoint. Elements of the environment that have line of sight to the user are patterned with texture information appropriate to the object they represent, and the textured geometry is further processed for lighting effects, such as variations in brightness from virtual light sources, and bump mapping (or similar techniques such as displacement mapping or use of an isosurface) to simulate how the texture should interact with such a virtual light source. Additionally other effects such as volumetric fog and particle effects may be included.

The final rendered image is then presented to the user, typically via a 2D or 3D television or via a head mounted display.

Often within such games, the user has an experience that they wish to share with friends and/or the wider world. To this end, as noted previously an entertainment device such as the PlayStation 4 ® can have a 'share' button on its controller to facilitate a capture of the image presented to the user, which can then be uploaded to a sharing site such as a social media site.

### Printing a 3D model of the environment using supplementary geometry

In an embodiment of the present invention, the user is provided with the option to select a moment within the game from which to create a 3D printed model. In this way, the user can create tangible mementos of their in-game experiences.

It will be appreciated that in-game geometry (vertices, polygons and the like) may be suitable to drive a 3D printing process. For example, the simple block-based environment within Minecraft® may lend itself to being rendered by a 3D printer.

However, this is the exception rather than the rule. A particular appeal of video games is their ability to present environments and characters that are not bound by the normal rules of physics. In particular, objects may exist in a predetermined relationship to each other without having physical connections (as exemplified by the notional character 'Blobman' in Figure 3A, whose hands and feet are not physically attached to his torso in this figure), whilst other objects may be defined only in two dimensions within the three-dimensional environment, such as curtains, capes and in many cases environmental components such as walls. This is because physical strength is not a requirement of the environment, where program rules prevent movement beyond certain boundaries, and the walls are simply decorative surfaces for textures demarcating those boundaries.

Hence a virtual environment may comprise several bounding surfaces that have zero thickness, upon which are placed physical objects, some of which may additionally be unstable in the real world. An example of such bounding surfaces may be the walls of the room 210 in the virtual environment 200 of Figure 3.

It is not feasible to print such a virtual environment using a 3D printer.

### Supplementary Geometry

Accordingly, in an embodiment of the present invention, supplementary printer geometry is provided that is used to modify elements of the environment that are unsuited to 3D printing.

Referring now to Figure 3B, in one embodiment, the supplementary printer geometry is defined by the game developer in a similar manner to conventional game geometry. For example, supplementary printer geometry for the character 'Blobman' may comprise rods 222A,B,C,D to connect the legs and arms to the character's torso, making the modified 3D character 220' a contiguous body suitable for 3D printing.

The supplementary printer geometry may replicate some or all of the existing in-game geometry in addition to the elements that support 3D printing, or may only comprise the elements that support 3D printing, with the combined supplementary and in-game geometry being used for 3D printing. Alternatively or in addition in some cases a partial replacement of in-game geometry may be used, for example to replace a sharp point on a sword or a stiletto heel with a rounded or broad surface, either for safety reasons or to provide a better bond for the object to an optional supporting surface when it is 3D printed.

Hence more generally the in-game geometry is supplemented by, and optionally at least partially replaced by, supplementary printer geometry for 3D printing that takes account of the physical requirements of the printing process and of the completed model under the effect of gravity.

Consequently when a user pauses the game (or game recording - see elsewhere herein) and selects a 3D snapshot for printing, the environment is modified using the 3D printing-compatible supplementary printer geometry, before the drawing list required by the printer is output either directly to a printer or to a file for subsequent use by a printer driver.

Similarly, supplementary printer geometry for 2D elements of the environment may be defined that has the thickness needed to provide adequate structural support for the environmental feature when 3D printed.

It will be appreciated that where the 3D model can also be coloured during construction, either by the application of ink or by the selection of different coloured plastics, then the textures used for the video game geometry can also be used to drive the colouring process for the model.

It will also be appreciated that the textures can also be used for the supplementary printer geometry to the extent that the in-game and supplementary geometries match. However, for elements of the supplementary printer geometry not found in the rendered game (such as the connecting rods in the 'Blobman' example above), either supplementary textures may be provided, or textures may be extrapolated from the existing textures, or no texture may be used. In the case that textures are extrapolated, optionally the texture may be extrapolated from the portion of the environment supporting an element against gravity (e.g. the ground, or in the case of Blobman, from the feet to the torso, and from the torso to the hands and head, respectively), as this is likely to create the most unobtrusive supporting structure within the model. Alternatively in the case of using no texture, the bare plastic (or other 3D printer material) is left exposed, making it clear to the viewer that this is a functional support that is not part of the original image. Which approach is preferred may be an artistic decision for the user or developer.

To limit the burden on developers, this supplementary printer geometry may be provided only in key areas of the game, for example where a particular puzzle is solved or a boss has been defeated. The option to create a 3D snapshot will thus only be enabled within the supported areas. Optionally in such areas additional 'bonus' geometry may be provided, such as exclusive victory poses that the user can select for their character to use within the 3D printed version of the environment.

However it will be appreciated that the supplementary printer geometry places a development burden on developers, and imposes a trade-off between the flexibility to print mementos of the in game experience and the amount of additional geometry that needs to be defined to support this ability. It will be preferable to increase the number of environments where this is possible whilst mitigating the burden on the developer.

### Printing a 3D model of the environment from a collection of images

In an embodiment of the present invention, the user is again provided with the option to select a moment within the game from which to create a 3D printed model. In this way, the user can create tangible mementos of their in-game experiences.

In an embodiment of the present invention, when the entertainment device receives an input indicating that a user wishes to create a 3D print of the current scene, the game state is frozen (e.g. paused) so that it can be analysed for 3D printing.

It will be appreciated that the in-game geometry, which might be considered a likely source of information for a 3D model, may be a mix of polygons, skeletal models, skin models, bump maps and physics derived procedural models or deformations to models, etc., that are typically only combined in one place, and in one format, which is when they are rendered for display on screen.

Consequently, in an embodiment of the present invention, a 3D model is constructed for 3D printing using these rendered images in preference to the potentially disparate in-game representations of the virtual environment geometry. However, a single rendered image will typically comprise insufficient information to fully model the virtual environment for 3D printing.

As was noted previously herein, during normal play the virtual environment is rendered for a particular viewpoint. Furthermore to enable high frame rates and efficient processing, then as part of this rendering process elements of the environment that are not visible from that particular viewpoint are culled early in the rendering process.

Consequently only the elements of the environment visible from the selected viewpoint are preserved and rendered. If one were to generate a 3D printer model of the environment using this render, then all aspects of the model that were not visible from that particular viewpoint would be missing or would have to be filled in using some form of interpolation algorithm. Clearly this would give rise to unsatisfactory results when the real printed model was viewed from any other angle.

Accordingly, in an embodiment of the present invention, while the game state is frozen the entertainment device generates a plurality of rendered images of the virtual environment from different viewpoints.

Preferably at least two opposing viewpoints are rendered, with the first viewpoint typically being the one originally displayed to the user. Between the two images, this results in the rendering of most if not all of the elements of the environment culled in the original rendered view.

Optionally three viewpoints are rendered, preferably equally distributed on a plane, with the first viewpoint being the one originally displayed to the user and the plane being horizontally centred on the direction of view of that first viewpoint. Again this results in the rendering of most if not all of the elements of the environment culled in the original rendered view, but is likely to capture more elements of the environment that may have been occluded by objects both in front and behind them and hence not rendered in either of the two viewpoints mentioned above.

More generally, as more viewpoints are distributed on the plane, fewer elements of the environment remain un-rendered. For example, the entertainment device may conduct a 'fly-by' within the environment, capturing *N* images, where *N* is for example between 2 and 360. The number of images captured is a trade-off between fidelity of the eventual model and the memory and processing capacity of the entertainment device needed to analyse the captured images (as discussed later herein).

Optionally, one or more viewpoints looking down from above the virtual environment may also be rendered (either as individual images or as part of a flyby sequence) to provide additional detail for those elements of the environment that are substantially parallel to the previously captured viewpoints on a single plane, such as the top surfaces of some environmental features.

In an embodiment of the present invention, metadata relating to the position and viewing direction of the virtual camera representing the viewpoint for each image is also recorded and associated with the respective image.

It will be appreciated that the virtual environment may represent a large area, whereas the 3-D model will encompass a limited area determined by the size of models that can be generated by a particular 3-D printer and the scale at which the environment is printed. Preferably the properties of the particular 3-D printer are known if it is in communication with the entertainment device (otherwise, a default model size may be assumed or the user may stipulate a size); similarly the scale at which the environment is printed may be selected by the user or may be automatically determined with reference to a key character within the environment, such as the user's avatar. This avatar may be chosen to be a particular size within the final 3-D printer model (as a nonlimiting example, 5 cm tall by default), and the extent of the environment to be printed at the same scale may thus be calculated. Alternatively, in a 'character print' mode, only a particular character, such as the user's avatar, may be printed, without surrounding in-game environmental features. This may be of particular value for cases where the user is allowed to customise their own in-game character, and becomes emotionally attached to it.

The equidistant distribution of two or more viewpoints may thus be centred on this key character, and may optionally use any in-game camera control logic to determine the necessary direction of view needed to centre the key character within each captured image.

Where the game presents a first-person view, then based upon the model size and an assumed or user-set scale, the centre point of the model can be calculated and the viewpoints can be distributed around it.

Combining the above approaches, the entertainment device may capture images by selecting sample points on a sphere of predetermined radius, and which is centred on that centre point. Optionally those sample points that are occluded by an environmental barrier (such as a point on the sphere below the ground or inside a mountain) may either be skipped, or the radius of the sphere may be locally reduced until the surface is no longer occluded by the environmental barrier. The sampling scheme may initially select viewpoints on the above mentioned plane comprising the original viewpoint and centre point and parallel to the horizontal axis of the original viewpoint, before optionally selecting one or more viewpoints on the sphere above this plane, and optionally one or more viewpoints on the sphere below this plane. The predetermined radius may be equal to the distance between the original viewpoint and the determined centre point of the model, to maintain consistency with the original captured image, or the original image and the subsequent additional image(s) may be re-rendered at a different effective radius, for example a minimum radius at which the field of view of the image encompasses the ground area that will be included in the 3D printed model. Notably, traditionally games use lower-fidelity models at greater draw distances to simplify the rendering process. Therefore optionally the radius may be constrained to a maximum distance equal to a rendering distance at which the game would select a lower-fidelity model of a key element of the image (such as the user's avatar). Further optionally, this may be overridden by a user for aesthetic purposes or because they wish to ensure that a particular environmental feature or combination of features is included in the final model. This may be of particular value for cases where the user is allowed to customise the environment, for example by creating so-called 'mods'.

In any event, the result is a set of images capturing two or more complimentary viewpoints of the virtual environment for a given game state.

It will be appreciated that the above image capture procedure may be controlled by the entertainment device. However, alternatively or in addition the user may capture images of the same scene from one or more different viewpoints by selecting these viewpoints themselves and using a conventional image capture process. These viewpoints may not correspond to the preferred distributions discussed previously herein. It will similarly be appreciated that images of the same scene from different viewpoints can be captured by different users at different times on different entertainment devices; providing a user has access to a pooled set of images (for example if they are posted to an online forum, or are stills extracted from a 'fly-by' video that moves or changes viewpoints, such as may be included in a trailer video for the videogame) then an equivalent set of two or more complementary viewpoints of the virtual environment may be obtained.

Given these images and optionally associated metadata relating to the viewpoint position and direction, an entertainment device can analyse these images to generate 3-D model data.

Several analysis techniques may be used, optionally in a complementary manner.

Silhouette analysis uses the edges of objects within the captured images to estimate the object's profile local to that edge. The object profile can then be extruded orthogonal to the profile for each viewpoint until it intersects with another extruded profile (typically extruded from another viewpoint), to create an approximation of the object's shape. It will be appreciated that as the number of viewpoints increases according to the scheme described previously herein, each extrusion will subtend a smaller angle around the object, resulting in a more accurate overall model of the object.

Stereoscopic analysis uses the relative displacement of the same objects within two overlapping viewpoints to calculate their distance from the or each viewpoint. From this information, a depth map can be constructed that is indicative of the 3D shape of the object in the region visible to both viewpoints. Hence again where more viewpoints are available, successive pairs of viewpoints can be used to build a map of the surface of a viewed object.

In either case, where there is no viewpoint information, this may be estimated by correlating environmental features between images, and selecting viewpoint positions and directions that provide the best correlation for the relative positions of these features.

It will be appreciated that silhouette analysis and stereoscopic analysis can be used to complement each other. For example the two techniques can be used to detect errors in each other's models; where the two techniques generate estimates of an object surface that differ by a threshold amount, the estimate that most closely matches an interpolation between nearby estimates of the object surface from the two techniques that are within a threshold agreement may be used, with the other estimate being discarded. Optionally, such areas of the model may also be highlighted for inspection and/or editing by the user prior to printing, as discussed later herein.

The above techniques are particularly useful where the image data is obtained from third parties (for example from screenshots on a forum), and there is no additional metadata available.

However, in the case of images generated and captured by the entertainment device, it is possible to also capture associated depth information generated by the entertainment device itself. As was noted previously, during a conventional render of a viewpoint, elements of the environment that are occluded from the rendered view are culled. This occlusion is determined, at least in part, by the relative distance of objects in the environment from the virtual camera; for example objects that are behind other objects are deemed to be occluded and thus culled. These distances are calculated by the entertainment device for this purpose. This means that there is an accurate and per-pixel (or even sub-pixel) resolution distance or 'depth' map available for each captured image.

In an embodiment of the present invention, this depth map is also captured and associated with each image captured by the entertainment device for use in the generation of the 3D model. In principle, this information can be obtained in a manner that is transparent to the operation of the renderer by copying the so-called z-buffer used when generating the image. Consequently the image capture process does not require modification of a game rendering engine in this respect.

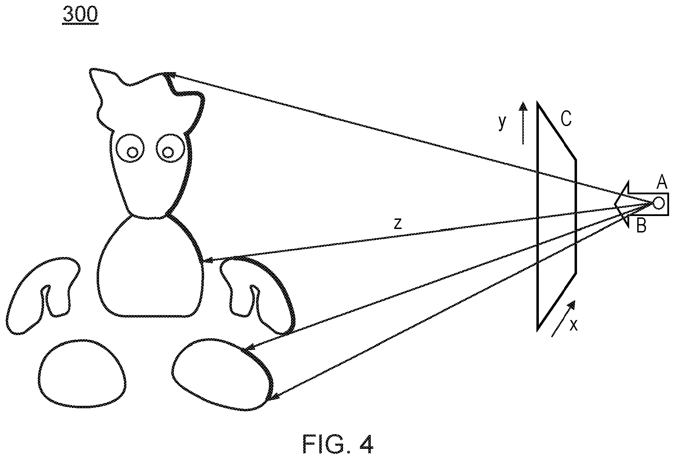

Referring now to Figure 4, given information regarding the position A and viewpoint direction B of each image, together with the associated distance information z, the pixels of each image can be projected to respective points within a shared virtual modelling space 300. In effect, each pixel is displaced from the position A of the image viewpoint by amount x,y,z in a co-ordinate scheme local to the image (but which may be rotated to a co-ordinate scheme common to the shared virtual modelling space, using known techniques). Here, x and y are the pixel co-ordinates in the captured image (represented by notional screen *C*), and z is the associated depth or distance value for that pixel from the camera position A. Only one column of pixels (i.e. for a single value of x) have been projected in Figure 4 for clarity, but it will be appreciated that all pixels of the image can be projected in this manner.

The result is that the pixels of each image will be positioned within the shared virtual modelling space at their correct position in 3D on the surface of a virtual object in the scene, as illustrated in Figure 4 using the example of Blobman. As each image is projected into the shared virtual modelling space, more of the surface of each object in the scene will be 'painted-in' in this manner. Where two images project the same pixel onto the same point in 3D space, the second projected pixel may be discarded or may replace the first pixel, or an averaging or majority-rules scheme may be used to select colour information.

It will be appreciated that pixels are two dimensional objects. Consequently in an embodiment of the present invention, when a pixel from an image is projected to a postion x;, yⱼ, zₖ in the shared virtual modelling space, in fact a voxel (a typically cubic 3-dimensional pixel) is created at that position, and the colour information associated with the projected pixel is used as the colour information for the voxel.

The effect is that a shell of voxels representing the visible surface of the virtual environment is built up by projecting the colour data of the image pixels in each image to x,y,z positions in the shared virtual modelling space.

It will be appreciated that instead of projecting plural images into a shared modelling space using the z-buffer depth information from the entertainment device, this depth information may be estimated using the previously discussed techniques of stereoscopic depth estimation and/or silhouette analysis and surface extrusion. Hence these techniques may also be used to drive the assembly of a voxel shell within a shared model space in the above described manner.

In any event, once all the images have been used, the resulting shell of voxels can be analysed for integrity. Any gaps in a surface (optionally below a threshold size) may be filled in by interpolation from the surrounding surface.

Having generated an estimate of the 3D shape of the environment in the form of the voxel shell, a 3D model can be generated for printing.

It will be appreciated that a model shell one voxel thick is unlikely to be strong enough when printed as a physical model.

Accordingly, the shell can be extruded to a predetermined thickness. The extrusion may be performed by adding adjacent voxels to each surface voxel on the side opposite to the side(s) from which they were projected into the shared virtual modelling space (i.e. on the inside or underside of the shell). The number of voxels added may be the lesser of *M* voxels or the number needed to reach an opposite existing surface of an object. *M* may be chosen to result in a thickness responsive to the weight and strength of the material being used to print the model.

Similarly, the lowest point within the (now extruded) model can be determined. At least two additional points, typically on the underside of the shell, can be extruded further to match the lowest point, thus providing at least three points of support for the physical model. Preferably, these points of support are distributed around a calculated centre of mass of the model.

To assist with determining feasible locations for supports, the thickness of the shell can be further varied to change the centre of mass, so that different locations for supports can potentially be chosen.

In this way, a 3D model of the virtual environment can be constructed from plural in-game images that will stay up when physically printed and is viewable from a plurality of angles.

The model is then sent to a 3D printer driver, which slices the model into layers from the bottom up. These layers are then successively printed by the 3D printer as described previously.

### Modifying the model

As was noted previously, a common feature of video games is that the objects therein are not bounded by physical laws, which can impede successful 3D printing of videogame elements. One solution described above is to provide supplementary printer geometry that modifies videogame elements so that they can exist (i.e. support themselves) when printed.

Similarly, in an embodiment of the present invention, either the in-game model or the image based voxel shell described previously is modified to take account of physical requirements of the 3D printed model.

As noted previously, the shell of voxels can be extruded to be *M* voxels thick, to provide some physical strength. This also addresses the problem of in-game objects of no thickness within the environment, as the geometry corresponding to these objects are extruded in the same way as any other element of the shell of voxels.

However for some elements of the environment, this may not provide sufficient physical support, or in the case of aerial objects in the environment, support may be missing entirely.

### Procedural Supplementary Geometry

Accordingly, procedurally defined modifications to the in-game geometry / voxel shell may be provided for the purposes of 3D printing. These procedural modifications provide structural strength and/or physical support for some elements of the virtual environment that it would not otherwise be feasible to replicate in a 3D printed model. It will also be appreciated that these procedurally defined modifications can be applied to in-game geometry instead of or as well as using supplementary printer geometry.

Hence hereinafter whilst for simplicity of explanation references to 'printer geometry' refer to the voxels created to define the 3D model for printing, and examples of procedural supplementary geometry are based on analysis of the voxel shell, it will be appreciated that these may equally refer to in-game geometry (whether partially augmented by supplementary geometry or not).

Procedurally generated or modified printer geometry may be generated by the entertainment device once the initial voxel shell has been generated.

The voxel shell is analysed to detect whether additional geometry is required, according to several basic rules.

One analysis step is to detect whether there are unsupported objects within the environment.

If so, then these may be made subject to a *de minimis* size threshold so that objects below the threshold, such as for example snowflakes, bullets etc., are ignored and subsequently not retained within the 3D model. The associated voxels in the voxel shell may be deleted. Optionally this step may be implemented in a modified rendering process so that these items are never rendered in the first place when collecting images for the model, making the analysis of the images simpler.

Meanwhile for objects that meet the threshold, printer geometry for a support structure such as connecting rod may be procedurally generated between the object and a nearby anchor point, the anchor point being a part of the environment ultimately connected to the ground. The ground itself can be assumed to be connected to the lowest point of the voxel shell. Optionally the analysis can proceed from the lowest part of the voxel shell upwards so that unsupported objects can be sequentially supported, enabling them to support subsequent objects in turn.

Consequently where a video game character is leaping into the air for example, a supporting rod will be formed between the base of their foot and the ground by creating a cylinder of voxels, for example M voxels thick by default.

However, the thickness of the rod may also be procedurally determined according to basic rules. For a given type of printer, the weight by volume of common 3D printer materials and optionally their compression and bending strengths will be known. In addition, the expected size of the printed model will be known. Accordingly, the entertainment device can estimate the weight of unsupported objects, and calculate the thickness of supporting rod needed to adequately support the object within the model. In particular where a connecting rod is partly or wholly lateral and hence may bend, the moment of the unsupported object is a function of its weight multiplied by its distance from the current position along the rod. Furthermore when constructing a connecting rod for such an object, the weight of the connecting rod itself may be a significant proportion of the weight. Consequently the rod may be thicker closer to the anchor point and taper towards the unsupported object as respective parts of the rod support a greater weight at the anchor point than at the unsupported object.

In another analysis step, the above principle can be applied to other parts of the voxel shell; for example a virtual model desk within a game may have legs that are too thin to support the total mass of the desk surface and any objects on the desk. For example, if the desk has a character standing on it, but the desk legs are only a few voxels thick, they may not be strong enough to support the physical model. Accordingly features of the voxel shell can be evaluated to determine the total weight they will be supporting in the model, and where this exceeds a safe margin for the cross sectional area of the voxel shell supporting this weight, this may be thickened by scaling up its cross-section and filling it with voxels. The principle may also for example be applied to trees within the environment, where the cumulative weight of branches and the trunk are used to locally modify the geometry of the branches or trunk to make their cross-section larger to accommodate the weight, in those circumstances where the existing geometry is locally insufficient to accommodate the weight when rendered as a 3D model using the particular materials associated with the 3D printer.

Subsequently, the centre of gravity of the adjusted model may be calculated to detect if it would fall over. If so, then either a support may be moved to restore stability, or optionally the voxel shell may be thickened in one or more selected places to alter the centre of gravity back towards a stable position.

As noted previously, two-dimensional components of the environment are extruded along with other parts of the initial voxel shell to create a three-dimensional object with at least a minimum thickness. However, this extrusion process can be further modified as described below.

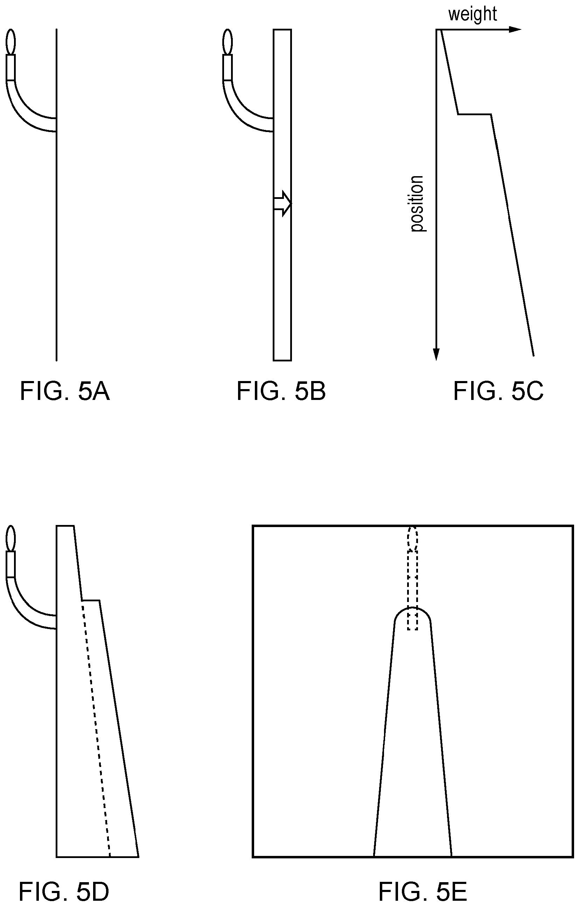

Referring now to Figures 5A-E, it will be seen that Figure 5A represents a two-dimensional wall from the environment 200, upon which a candle and candlestick are placed within the game. Figure 5B then illustrates an extrusion process to extend the wall in a direction normal to the wall plane and opposite to the side from which the image was projected, to procedurally generate geometry describing a wall with a predetermined thickness, for example of M voxels. However as can be seen in Figure 5C, the cumulative weight of the physically printed wall will change according to the position on the wall, and also encounters a step change for parts of the wall additionally supporting the candle and candlestick. Accordingly, a wall of constant thickness may be unsuitable as the thickness of the wall near the base may be insufficient to adequately support the cumulative weight of the model.

Accordingly, with reference to Figures 5D-E, then starting with a minimum preferred thickness of extrusion at the top of the wall, the thickness of the extrusion increases as a function of cumulative weight, resulting in a step change in thickness at the point of attachment of the candlestick to the wall to provide additional support. It will be appreciated that procedural rules may thicken a region around such points of attachment, such that the wall is thickened slightly before the load of the candlestick is applied to the wall, as illustrated in Figures 5D-E. In addition, the procedural rules may accommodate the additional mass of the supportive thickening itself when extruding lower portions of the wall. Finally, the load imposed by the candlestick and the supporting region may be distributed laterally as well as vertically, so that the thickened supporting region splays sideways as it propagates down the wall, as shown in Figure 5E.

The procedural rules may also interact with additional information provided by a game developer, to assist in generating desirable supplementary geometry automatically.

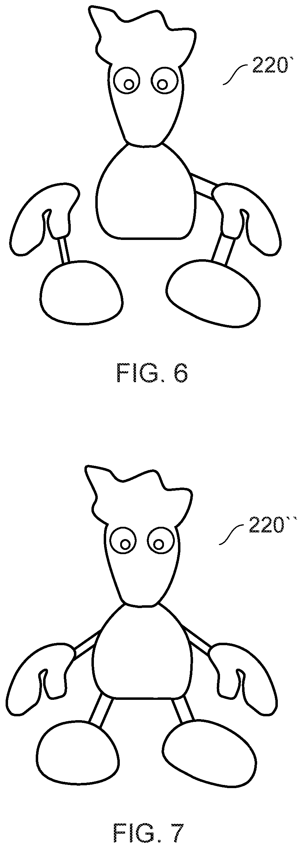

For example, the previously noted rule that a connecting rod is procedurally generated between an unsupported object and the nearest anchor point, where the anchor point is a part of the environment ultimately connected to the ground, may result in 3D model of Blobman 220' as illustrated in Figure 6. It will be appreciated that when the character's hands are analysed, it is likely that they are closer to the character's feet than to the character's torso, and possibly also that the character's torso will not yet be connected to an anchor structure itself. Accordingly the procedural rules may attach the character's hand to the only grounded anchor points available, which are the feet; subsequently the torso may be anchored to the closest single anchor point, which is now one of the hands. The result is a structure that, whilst stable, does not conform anatomically to what the user might expect.

Accordingly, game developers (or users) may identify preferred points of connection between elements of the environment in order to guide the procedural generation of connecting rods or other connecting/support structures. These points of connection may be defined by use of a reserved value within one or more colour channels, enabling points of connection to be identified by use of a specifically coloured identifying pixel within an image; for example if the value 128 was reserved on the blue channel to denote a connecting point, then this can be used in the example of the Blobman character 220" of Figure 7 to specify where preferred connecting points exist on the model. These reserved values are then used within the voxel shell, creating identifiable anchor points for use with the procedural rules. For example, matching values in the other two colour channels of the identifying pixel can be used to indicate paired connecting points, so that red and green values in the identifying pixel could be the same for the hand and the torso, causing these to be identified as sections to be connected together. In this way, artistic control of the placement of connecting structures can be maintained by the developers without the need for separate metadata. In the case of Blobman, this could be used to ensure an anatomically acceptable set of connecting rods, as can be seen in Figure 7. Meanwhile, the rules for procedural generation of the connecting/support structure will still determine the required cross-section needed to adequately support the printed structure.

Alternatively or in addition, the developers can provide texture or model metadata either indicating an anchor location, or conversely indicating a 'keep off' area where support structures should not be attached, such as a character's face. The system may then calculate the positions of support structures in areas that are not marked as 'keep off'. A combination of these approaches may be used, so that for example identified anchors are used whilst the centre of gravity of the model is more than a predetermined threshold distance within the area defined by supports intended to rest on the ground, but if the centre of gravity moves within this predetermined threshold difference, then one or more supports may be repositioned as needed providing they do not move into a 'keep out' region.

Again it will be appreciated that for elements of the supplementary printer geometry not found in the rendered game (such as the connecting rods in the 'Blobman' example above), textures (colours) may be extrapolated from the existing voxel shell, or a no colour may be specified. In the case that colours are extrapolated, optionally the colours may be extrapolated from the portion of the structure supporting an element against gravity (e.g. the ground, or in the case of Blobman, from the feet to the torso, and from the torso to the hands and head, respectively), as this is likely to create the most unobtrusive supporting structure within the model. Alternatively in the case of using no texture, the bare plastic (or other 3D printer material) is left exposed, making it clear to the viewer that this is a functional support that is not part of the original image. Which approach is preferred may be an artistic decision for the user or developer.

It will also be appreciated that the pixel resolution of the rendered images may be higher than the voxel resolution of the 3D printer at the scale chosen for printing. Consequently features of the rendered environment may sometimes have a high spatial frequency relative to the voxel resolution of the 3D printer. Accordingly the images may be filtered to a compatible resolution before projection into the shared virtual model space, to remove such high-frequency detail and thereby avoid aliasing effects in the resulting model. In this case, where reserved colour channel values are to be used by procedural rules, these are preserved or reinserted into the lower resolution image after filtration. The depth information may be similarly filtered.

It will be appreciated that such filtering may also be applied to the textures and/or geometries of in-game models being used as the basis for generating a 3D printable model.

### Object Selection

The above discussion has assumed that a region of the virtual environment displayed to the user will be replicated as a 3D model. However, optionally the user may specify one or more objects in the environment for 3D printing alone; for example, the user may select to just print their avatar, or their avatar and an opponent.

This selection may be done for example by a user interface for defining a bounding box around the desired object(s), or by a user interface for indicating specific objects within the game environment using a cursor or reticule.

Where the object(s) are selected in this manner in isolation from a supporting surface, a default surface such as a flat panel may be generated having an area responsive to the size of the selected object(s). The selected object(s) can then be coupled to the support surface using the techniques described herein.

### Editing

Once the printer geometry has been obtained using the above techniques as applicable, then optionally they may be transferred to an editing application for the user to preview or modify the model before sending it to the printer. For example it may be desired to review the model for possible errors, and/or to edit the pose and positioning of certain key characters. The editor may likewise enable the addition of decals, either purely to painted textures, or to the surface structure of objects for example by deleting surface voxels so that the user can effectively engrave messages into a surface of the model. The editor may also provide automated and/or guided correction of model errors, such as correcting overlapping polygons, interpolating gaps, repositioning of connective structure anchor points, adjusting object wall thicknesses and the like.

### Final Print

Once the user is satisfied with their 3D model, it may be sent to a printer. As described previously, a printer driver analyses the model and divides it into layers of voxels for successive printing.

Where the printer is a domestic device either physically attached to the console or sharing a home network, then the printer driver may be implemented on the entertainment device, and the resulting drawing list is sent to the printer by the entertainment device.

However optionally a printing service may be provided by the entertainment device's network (that is to say, a network provided for example by the manufacturers of the entertainment device). This may allow access to a more expensive and sophisticated 3D printer than the average consumer could afford, and consequently a better quality model. In these circumstances either the printer driver may still be on the console, to distribute processing load among users, or may be at a central server connected to the 3D printer. In the first instance local printer drivers will generate drawing lists that may be sent securely to a central print queue server, together with meta data relating for example to the postal address or contact details of the user. In the second instance the entertainment device securely sends the 3D model printer geometry to a central printer driver that performs the relevant analysis to generate the required drawing lists before queueing them for printing. In either of these cases, printing of the model may be contingent upon the payment of a fee, for example via a payment card registered with the entertainment device's network, or similarly may be contingent upon the receipt of a voucher which might be earned for example as a trophy or other in-game award, or as part of the purchase price of a game, entitling the user to the creation of a predetermined number of 3D models from that game.

### Waste Materials

It will be appreciated that 3D Printing techniques such as selective laser sintering can trap large quantities of the raw printer material inside the resulting model. This is because such techniques apply successive layers of powder across the top of the model during printing, fusing only a small proportion corresponding to the model's periphery but leaving the remaining powder inside that periphery untouched. The overall result is a volume of powder within which is a fused shell, with the powder outside that shell being removable, whilst the powder inside the shell is trapped.

This creates unnecessary costs in terms of wasted raw materials. It can also affect the balance of the resulting objects. Consequently it is commonplace to include vents or openings in models purposely designed for 3D Printing to allow the waste powder to be poured or washed out.

However, such vents or openings are not present in videogame characters and are not desirable.

Accordingly, in an embodiment of the present invention, if a powder-based printer is to be used, a procedural rule is implemented to calculate the effective volume of space within objects in the printed scene. Where that volume exceeds a threshold amount, the object is treated as a hollow body and a procedural rule creates an opening in the voxel shell of the hollow body of a size that allows printer powder to flow out. Preferably, the opening is located on the underside of the hollow body and/or on a side facing away from the original viewpoint displayed on screen to the user when they indicated that they wanted to print the scene. The opening may be a hole in the voxel shell, or preferably an annular gap forming a ring or some other shape of closed loop. In the case of an annular gap, this results in a loose cover in the printed body that can be removed to allow the powder out, but which can then by adhered back onto the model, minimising the aesthetic impact of removing the powder on the finished object.

It will be appreciated that a 3D printed scene may comprise multiple such hollow bodies. For example, the scene may comprise the ground, a character such as Blobman, and a tree. The ground is typically an open shell. Meanwhile the tree rests upon it, with the ground forming the base of the tree. Following calculations of the volume within the model, the tree trunk may be identified as a hollow object. Accordingly, a hole may be created in the ground beneath the tree, visible only if the model is viewed from the underside. By contrast, the Blobman character is supported by connecting rods above the ground. Consequently if the character torso is identified as a hollow object, an annular gap is included facing away from the original viewpoint, optionally at a position a threshold distance from any connecting rod. This allows the torso to be drained of powder but also to be repaired by affixing back in place the removable component of the torso created by the annular gap.

Optionally, the procedural rule may use features of the object itself to reduce the aesthetic impact of the hole or annular gap, for example by setting some or all of one or more edges of the hole or gap to follow adjacent a boundary between texture colours in a model, and/or to follow adjacent a ridge or other discontinuity in the model surface.

The system may use the 3D model data to estimate the volume of printer raw material needed, and provide a quote estimating the cost of printing the model before the user commits to doing so. Similarly the system may estimate the time needed to print the model.

### Scene / Object Selection

It will be appreciated that the above techniques are predicated upon the selection, by user, of a scene or character to print from within the videogame. Whilst in some games it may be possible for a user to adjust a pose of a favourite character in a manner they prefer without interference from other in-game events, it is more likely that memorable moments within a game are associated with frenetic activity on the part of the user and/or rapid action by in-game characters or environmental features of the game. During such moments the user may not be able to anticipate when to freeze the game action for the purposes of a selection, or may not have the reaction time necessary to freeze the game action the moment they decide that a displayed scene is desirable, particularly when games typically run at 30 or 60 frames per second.

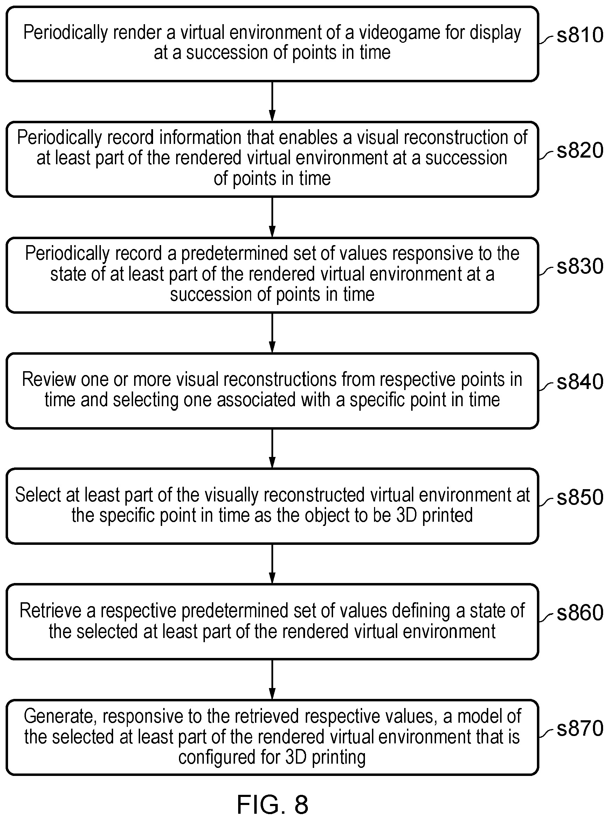

Accordingly, referring now to Figure 8, in an embodiment of the present invention a method of selecting an object from a videogame to be 3D printed comprises:
A first step s810 of periodically rendering a virtual environment of a videogame for display at a succession of points in time. As noted above, typically the period will be every thirtieth or sixtieth of a second.

A second step s820 of periodically recording information that enables a visual reconstruction of at least part of the rendered virtual environment at a succession of points in time. Typically the period will be the same as the rendering period, by may be every N^{th} rendering period, where N is in the range 2-60.

The information that enables a visual reconstruction of at least part of the rendered virtual environment will typically take the form of a video capture of the rendered image. In turn this will typically take the form of hardware video encoding of the output video image by the device hosting the game (for example the PlayStation 4) to hard disk. Alternatively or in addition, the game itself may perform software video encoding or just dump the rendered video image to hard disk. In this latter case, software video encoding is likely to be processor intensive and so may be limited to those circumstances where spare processor capacity is available, whilst storage of raw video frames without encoding or with minimal encoding uses less processor resources but comparatively more memory, and so the number of frames of video that can be recorded may be much smaller in this latter case.

Alternatively or in addition, the videogame may store information allowing a reconstruction of the rendered image by the videogame itself, such as draw lists (instructions to a graphics card) and associated asset information and game state data to allow re-rendering of the game state at previous points in time.

A third step s830 of periodically recording a predetermined set of values responsive to the state of at least part of the rendered virtual environment at a succession of points in time. Again the periodicity will typically be the same as that for the recording of information to enable visual reconstruction.

As will be described later herein, these sets of values comprise values that relate to those parts of the rendered scene that may subsequently be generated as models for 3D printing using for example any of the techniques described previously herein. It will be appreciated, for example, that a video capture of the rendered image alone may be insufficient to generate a model of a video game character at a particular moment in time, and consequently information enabling reconstruction of that model will be needed in addition to the video capture.

It may then be assumed that at some point the user decides they wish to 3D-print a moment from the game. The user may indicate this wish by pressing a button on the controller, such as the pause button, to access the option to review one or more visual reconstructions from respective points in time and selecting one associated with a specific point in time.

In one instance, the game may provide the user with access its own video recordings or to re-renderings of the scenes to the extent that its recorded information allows. This arrangement may be suitable for circumstances where a user's reaction times prevent them from selecting a momentary event as it happens, prompting them to 'rewind' by only a few seconds back to that event. As noted above, such video recordings or detailed visual reconstruction data is likely to be time-limited due to storage and processor constraints, and so in this instance, the game may only record sets of values for a predetermined number of points of time amounting to a period in the range of 0.1 to 60 seconds.

In another instance, the operating system of the host device may provide the user with access to encoded video recordings, either directly via the operating system interface or embedded within a user interface of the game. Because encoded video is much more compact than raw video, the host device may record for example 1, 3, 5, 10, or 15 minutes of displayed video in a rolling loop (depending on prior user settings). Longer recordings may be possible if storage capacity permits. It will be appreciated that where such video recordings are provided, a matching loop of predetermined sets of values are recorded in association. Consequently in this instance whilst the user may push a button to pause the game and access the above-mentioned rewind facility to review earlier moments from the game, optionally the user may wish to wait for a natural pause in a game such as the end of a level or a checkpoint before pushing such a button to review earlier moments in the game. Consequently the game user interface may also provide the review option as part of such an end of level or checkpoint notification. This allows a user to still access the 3D printing facility without interrupting frenetic gameplay action and hence their immersion within the game.

Having indicated a desire to review earlier moments from the game in a manner such as those described above, then a fourth step s840 comprises reviewing one or more visual reconstructions from respective points in time and selecting one associated with a specific point in time.

Hence as described above this may involve queueing and reviewing through recorded video of the game or re-rendered scenes of the game to identify a specific point in time comprising a scene or object of particular interest to the user.

In a fifth step s850 the user then selects at least part of the visually reconstructed virtual environment at the specific point in time as the object to be 3D printed. Which parts of the virtual environment can be selected may depend upon the quality of the predetermined set of values previously recorded, as discussed later herein. The interface for selection may be any suitable interface, such as a mouse or controller guided pointer that can be used to hover over and select one or more elements of the visually reconstructed virtual environment, with selection being successful for those elements that can be selected. Alternatively the selection techniques described herein relating to camera viewpoint and area around a nominated character such as the user's avatar may be used for example to select a more complete scene, which could be arduous to manually select using a point-and-click interface.

As will be described later herein, in an embodiment of the present invention, one or more indicators is displayed relating to how well or how feasible it is to 3D print a selected object as seen in a particular video frame, based on factors such as the pose and/or orientation of the object, the cost of printing the object and/or the current availability of raw material (where this can be reported to the system), the quality of the available data from which to generate the 3D model of the object, and so on. This enables a user to choose a moment in time in which the selected object may generate a pleasing model.

Hence in this way typically one or more game characters such as the user's avatar and/or non-player characters may be selected, and/or a given volume or area of a complete scene may be selected for printing.

A sixth step s860 then comprises retrieving a respective predefined set of values defining the state of the selected at least part of the rendered virtual environment. As noted above and as described in detail below the respective values may vary in quality and consequently the retrieval process may vary as a function of this quality.

It will be appreciated that if the respective values comprise data that serves to identify which element or elements of the at least part of the visually reconstructed virtual environment can be selected, then the step s860 of retrieving the respective predefined set of values for the specific point in time may precede the step s850 of selecting at least part of the visually reconstructed virtual environment at the specific point in time as the object to be 3D printed. More generally it will be appreciated that steps of the method described herein may be re-ordered or run concurrently in any suitable order that achieves substantially the same final outcome as the order described herein.

Finally, a seventh step s870 comprises generating, responsive to the retrieved respective values, a model of the selected at least part of the rendered virtual environment that is configured for 3D printing.

It will be appreciated that any of the techniques described previously herein may be used for this purpose, including the provision of supplementary geometry or the generation of additional geometry through procedural rules, and the automatic or manual editing of meshes to improve mesh integrity. It will also be appreciated that the generated model may be output to a 3D printer local to the host device, or the generated model (or suitable intermediate model data for generation of a model, such as that used as input to the techniques described herein) may be output to a third party printing service.

As was noted above, the predetermined set of values may have different quality levels corresponding to the fidelity with which the state of the game is recorded by those values at each point in time.

For the convenience of explanation, reference will be made to 'high quality', 'medium quality' and 'low quality' sets of values, but these may be equally thought of as respective sets of values of a first size, a second, smaller size and a third, yet smaller size. Hence these may also be respectively referred to as first, second and third quality sets of values, or datasets.

The high quality set of values may for example comprise a suitable selection of one or more selected from the list consisting of:
i. game specific values that would be sufficient to allow the particular game to reconstruct that point in time within the game, given the games' access to the game engine and game assets (e.g. similar to a game save);
ii. at least part of a drawing list sent to a graphics card at a point in time;
iii. one or more textures or identifiers of textures used by a graphics card at that point in time;
iv. mesh data corresponding to the state of at least part of the virtual environment at that point in time (for example as used in some of the above described 3D printing techniques), optionally including supplementary geometry;
v. Z-buffer information providing depth data (for example as used in some of the above described 3D printing techniques) at that point in time; and
vi. descriptors relating to the warping or modification of meshes, textures or any surface appearance, for example in relation to a particular in-game character.

The high quality set of values may use any suitable compression scheme to reduce data size, depending on available processor capacity; for example only saving a full high quality set of values every M^{th} point in time, and relying on saving incremental or differential values in between.

It will be appreciated that the high quality set of can potentially enable a high fidelity reconstruction of the visible scene displayed to the user at the corresponding point in time (e.g. item i. in the above list), and hence may double up as the recorded visual representation.

It will also be appreciated that the high quality set of values may comprise sufficient assets to construct a desired 3D model without subsequent access to the game assets themselves, depending on the values included (for example items iii. and iv. above, or item v. in conjunction with video data); alternatively access to the game itself may be assumed (for example in the case of items i. and ii. above), or may be used to enhance the potentially independent data set.

The medium quality set of values may for example comprise a suitable selection of one or more selected from the list consisting of:
i. game specific values identifying a level or region of the game displayed at a particular point in time (for example; level 5, region 6, coordinates XYZ);
ii. game specific values that would be sufficient to allow the particular game to reconstruct the pose of a particular in-game character at a point in time;
iii. one or more textures or identifiers of textures used by a graphics card for a particular in-game character at that point in time;
iv. mesh data corresponding to that particular in-game character at that point in time, optionally including supplementary geometry;
v. Z-buffer information providing depth data corresponding to that particular in-game character at that point in time; and
vi. descriptors relating to the warping or modification of meshes, textures or any surface appearance, for example in relation to a particular in-game character.

Again, the medium quality set of values may use any suitable compression scheme to reduce data size; for example only saving a full medium quality set of values every M^{th} point in time, and relying on saving incremental or differential values in between.

It will be appreciated that the medium quality set of values typically enable a high fidelity reconstruction of a particular character displayed to the user at the corresponding point in time.

It will also be appreciated that the medium quality set of values may comprise sufficient assets to construct a 3D model of the particular character without subsequent access to the game assets themselves, depending on the values included (for example items iii. and iv. above, or item v. in conjunction with video data); alternatively access to the game itself may be assumed (for example in the case of items i. and ii. above), or may be used to enhance the potentially independent data set.

It will be appreciated that the medium quality set of values may capture information relevant to more than one character in a scene; for example whilst the user's avatar may be a default selection, information for non-player characters that the user interacts with at a particular point in time, or who are within a predetermined radius of the user's viewpoint or the user's avatar at that time may be included as part of the medium quality set of values.

It will also be appreciated that high quality and medium quality datasets may be interleaved; hence for example a high quality dataset may be recorded at a low frequency, in the order of seconds or minutes, providing information that would enable a representative reconstruction of the environment for a character reconstructed using medium quality data selected from a particular point in time occurring between low-frequency recordings of the high quality dataset. In this way a model of a scene capturing the precise desired pose of the main characters can be generated using less data storage.

The low quality set of values may for example comprise a suitable selection of one or more selected from the list consisting of:
i. values identifying a level or region of the game displayed at a particular point in time (for example; level 5, region 6, coordinates XYZ);
ii. values identifying a particular in-game character; and
iii. values identifying a particular predetermined state for the in game character at that point in time.

Again, the low quality set of values may use any suitable compression scheme to reduce data size; for example only saving a full low quality set of values every M^{th} point in time, and relying on saving incremental or differential values in between.

It will be appreciated that the low quality set of values typically enable a high fidelity reconstruction of a particular character displayed to the user at the corresponding point in time, if that character adopts predetermined states known to the game, such as pre-set animation frames.

It will also be appreciated that the low quality set of values typically do not comprise sufficient assets to construct a 3D model of the particular character without subsequent access to the game assets themselves.

Again it will be appreciated that the low quality set of values may capture information relevant to more than one character in a scene; for example whilst the user's avatar may be a default selection, information for non-player characters that the user interacts with at a particular point in time, or who are within a predetermined radius of the user's viewpoint or the user's avatar at that time may be included as part of the medium quality set of values.

Again it will also be appreciated that high quality and medium quality datasets may be interleaved with low quality datasets. For example, an in-game character may use predetermined animation frames for the majority of point in time, but these may be modified using so-called 'ragdoll physics' in specific and dramatic circumstances such as explosions, falling or impacts. Consequently the predetermined set of values used may switch from low quality to medium quality, or incorporate medium quality elements, when the game switches from predetermined animation to ragdoll physics for a character.

Again the high quality dataset may be recorded at a low-frequency to provide representative background of the scene; however if access to game assets is assumed to be a requirement for low quality values, then values identifying the displayed location within the game at the point in time may be sufficient to allow reconstruction of the background if desired. Conversely it will be appreciated that if access to game assets is deemed necessary for 3D printing, then the medium quality datasets and high quality datasets may be simplified by use of such location data as well.

Any of the above sets of values may also incorporate information identifying the game, optionally including the game version (such as the platform the game is compiled for, and/or the particular iteration of the game on that platform).

It will be appreciated that the above described high, medium and low quality datasets are non-limiting examples, and that optionally, one, two or four or more different quality data sets may be selected from, and that for a given quality data set (e.g. 'medium', elements described above as corresponding to 'high' or 'low' may be used in that medium data set if deemed appropriate by a designer, and vice-versa for other quality datasets.

As described previously, a common usage scenario for 3D printing using the above described techniques will be where a player of a videogame either pauses the game shortly after an exciting moment they wish to memorialise, or where the game comes to a natural pause at the end of a level or at a checkpoint, and during this pause the user then reviews the visual representation of the game to identify the particular moment in time.

In these circumstances, it may be straightforward to record a loop of data comprising values that may be used to form high-quality, medium quality and/or low quality datasets for a short period of time (in the order of a few seconds), for example by saving to RAM, which is fast but of limited capacity. Each predetermined set of values may have a time stamp or counter enabling it to be associated with a particular frame of recorded video or other visual representation of the displayed game image.

When an old set of values is to be overwritten in this loop, a high quality, medium quality and/or low quality dataset can be extracted from it and written to the hard drive with its timestamp or counter. Typically the hard drive is slower for writing but has much larger capacity. It will be appreciated that the loop of data can be written directly to the hard drive rather than RAM if this is achievable without compromising gameplay. It will also be appreciated that the loop of data can be written at the desired quality level or interspersed sequence of levels directly, rather than writing a loop comprising data that can be subsequently converted into a dataset of the desired quality level(s).

In either case, the data may be recorded by the videogame itself or by the operating system of the host platform (for example via a standardised data interface between the operating system and games that support the 3D printing facility described herein).

In any event, in these circumstances a 3D printing system hosted on the videogame platform will also have access to the predetermined set of values and optionally also to in-game assets on the videogame platform, whether this platform is a handheld or domestic videogame console or PC, or a cloud-based videogame platform such as one providing a video game streaming service to an end-user.

In addition, due to the capacity and writing speed of RAM and/or hard drives on the platform, high-quality or medium quality datasets may be easy to record at the desired frequency of points in time (as noted above, typically equal to the frame rate of the videogame).

Consequently, it is relatively straightforward for the 3D printing system, based upon the retrieved predetermined set of values, to collate the required information needed to generate a high quality model as described herein of at least a predetermined character, and optionally of a scene, corresponding to a particular point in time during the user's gameplay.

By contrast, another usage scenario makes this more difficult. It will be desirable for users to be able to export recorded video of their gameplay and associated predetermined sets of values to a third party hosting service such as Twitch® or YouTube®, so that other users could watch their gameplay and similarly select memorable moments during that gameplay for 3D printing. In these circumstances for example, and more generally, steps s810 - s830 may be performed by a device hosting the videogame, whilst the remaining steps s840-870 may be performed by a second computing device belonging to the subsequent user (although in the case of game play provided by streaming video game images from a server, all the steps may still be by the same server).

Assuming that the 3D printing system itself is readily available (for example as part of the operating system or as a free or purchasable download) then in these circumstances there are two additional considerations.

The first consideration is that it is preferable for third-party systems to handle this information transparently. Consequently the associated predetermined sets of values may be incorporated into user data fields provided by a given video format, either directly or by using a universal resource locator (URL) that allows the 3D printing system to point to a server to which the associated predetermined sets of values have been uploaded, for example a server maintained by the 3D service, game publisher, operating system, and/or platform provider. The complete URL may as a non-limiting example take the form of a sequence of identifiers, such as http://www.exportserver.com/username/gamename/recordingID?framenumber.

In this case the only the username, game name and recording ID may be included, for example in video header data; the server address may be included with the 3D printing system software, and the frame number corresponding to the user's selected point in time can be calculated to construct the full correct URL. It will be appreciated that potentially a game name may not be needed in the URL if the recording ID is sufficiently unique on a per user-basis, and similarly a username may not be needed in the URL if the recording ID is sufficiently unique across the full user-base.

Where the predetermined set of values is incorporated into the data fields directly, then space constraints may determine what quality datasets can be used. By contrast where a URL is used, this space constraint is lifted.

Hence where a 'sharing' function is provided by the game and/or the operating system, this function may export video in a conventional manner, or where specified by a user, it may export video comprising predetermined sets of values where space within the video format permits, or it may export video comprising URL data and separately it may export predetermined sets of values to a server which then makes the values available at the corresponding URL.

The second consideration is that a random viewer of such a video may not have their own copy of the game. Consequently where the predetermined set of values stored in association with the video are of a type that assume access to videogame assets, this can potentially prevent such a viewer being able to generate a 3D model from a selected point in time within the video.

Accordingly, the 3D printing system may use information included in the predetermined set of values to identify as necessary the game, and for a selected point in time, the location within the game, the character(s) within the game, and/or an animation frame for such a character. This information may then be sent as part of a request to a server maintained by the 3D service, game publisher, operating system, and/or platform provider, which may be the same as the server mentioned above or a different server. In response to the request, the server may send those game assets necessary to reconstruct that point in time for 3D printing; for example mesh data and optionally texture data for a specific game character, optionally for a specified pose, or alternatively use them itself to implement techniques described herein to prepare a 3D printable model for review by the user, as discussed below.

Clearly, where the viewer of such a video does have their own copy of the game, then the 3D printing system may operate in a similar manner to the first usage scenario described above.

In either case, the 3D printing system can thus make use of available or provided in-game assets as necessary to generate a high quality model of at least a predetermined character, and optionally of a scene, corresponding to a particular point in time during the videoed gameplay.

It will be appreciated that other combinations of a videogame hosting device such as the PlayStation 4, and a server/cloud comprising relevant game assets, may be envisaged within the scope of the present invention.

For example, the videogame hosting device may host game assets used during gameplay, whilst the server/cloud holds game assets for a game enabled for 3D printing. In turn this may mean that it holds conventional game assets similar to those of the videogame hosting device and/or it may mean that it holds game assets specifically augmented or modified for the purposes of 3D printing, for example using one or more techniques described previously herein.

Using this arrangement, it is not necessary for the videogame hosting device to transmit game assets to the server/cloud, and the predefined set of values may thus comprise information identifying the relevant game, and identifying the relevant scene or character and any relevant pose data, for example in a manner described previously herein.

For example in an embodiment of the present invention, the game or the operating system on the videogame hosting device transmits the predefined set of values to the server/cloud and receives a uniform resource locator (URL) from the server/cloud pointing to a 3D printable version of the videogame scene or character generated by the server/cloud.

Typically this 3D printable version is constructed using techniques such as those described herein; using the predefined set of values, the relevant game assets are retrieved, and if necessary posed appropriately according to any supplied pose information in the predefined set of values; the server/cloud may then perform mesh repair, substitute elements of the mesh for versions adapted to 3D printing, or use procedural rules to adapt the mesh, generate supports for elements of the model, and/or adapt the model to allow for the recovery of waste printer material as described previously.

The URL may point to a data file in a format suitable for 3D printing, for example a format selected by the user when transmitting the predefined set of values, or may comprise parameter data stipulating a format to be used to create the data file when the URL is used to access the server/cloud.

In either case the 3D printable version of the videogame scene or character, and/or a data file for a 3D printable version may have digital rights management protection applied to it in any suitable form.

The data file may then be returned to the videogame hosting device if this is locally connected to a 3D printer or has means to forward the data file to a third party 3-D printing service, or the data file may be sent to a 3D printing service associated with the server/cloud.

### Printing Fitness

It will be appreciated that the above systems and techniques are able to provide 3-D printable models derived from selected moments in a videogame, but that the processing, modifications, materials and fidelity of the model can vary.

Factors contributing to this variance can depend for example on the nature of the in-game object itself (for example whether it is made of one or multiple separate elements, their relative thicknesses and the like), its pose at the selected moment to be modelled (for example whether this provides suitable point(s) of contact with the ground that will support the object's centre of gravity), the quality of data recorded at the selected moment (for example, direct from within the game, or high, medium or low quality sets of values as described previously herein); how the model is generated (for example, using developer-supplied supplementary model data, and/or procedurally generated model data, which in turn may be generated from multiple images or directly from in-game data); and finally potentially the type of 3-D printer available to create the model itself (for example, its resolution, or whether it has sufficient raw material to complete the model, or whether a user has sufficient credit for the materials required in the case of a printing-as-a-service implementation).

Consequently, in the present invention, one or more indicators of printing fitness are calculated for a candidate moment of the game that the user is reviewing, whether this is in-game (for example when a game is paused, and/or when a specific 3-D printing button or menu option is selected), or based upon recordings either held on the local game hosting device or viewed on a video as described previously herein.

Optionally, the one or more indicators may be calculated for each moment. However this is likely to be computationally expensive. For an uploaded video with associated data on a server, optionally the server may perform these computations when computing resources are available, so that the or each indicator is available for each frame when someone subsequently watches the video; meanwhile, for a local game-hosting device or a cloud streaming host, it may be desirable to only perform this calculation on a paused game state, or when browsing recorded data, optionally only for video frames that the user lingers on for a predetermined period of time, or otherwise indicates interest in, for example by pressing a button. This is because it is likely that during normal play of the game, there will be insufficient spare computing resources to perform the analysis. However it will be appreciated that if the resources are available, then optionally the analysis may be performed concurrently with normal game play.

The analysis may be performed by the game, the OS of the host system, or a separate application, or a combination of two or three of these. For example, the game, OS and/or separate application may access a library of one or more routines for performing some or all of the analysis process. Alternatively or in addition the game, OS and/or separate application may have one or more routines in-built for performing some or all of the analysis process.

As noted previously, a number of factors may contribute to the potential success or feasibility of generating a satisfactory 3D print of a object in the videogame. Not all of these factors need to be considered in order to provide an indication of printability or control / veto of a 3D print selection, but calculation of these factors is discussed in more detail below.

Optionally, some or all of the factors that are calculated may be presented to the user to inform them about what aspects of the process are potentially causing a problem. For example, if the problem is one of an unsupported centre of mass, insufficient printer material, or insufficient credit, it is useful for the user to identify which of these different possible causes to remedy.

Similarly optionally, some or all of the factors that are calculated may be used to generate a combined printability score. This can provide the user with a much simpler assimilation of the printability of a particular frame from the videogame, particularly if they are cueing or reviewing through a record of gameplay. For example, a traffic-light scheme may use a green indication to identify frames where a particular object can be printed without further intervention, a yellow indication to identify frames that could be printed after some user-controllable or user-authorisable change is made, and a red indication to identify frames where there may be some inherently unprintable aspect of the scene, or where a combination of factors suggests that significant modification to the scene is required for printing, for example requiring omission of an object, or possibly assessment and/or modification by a support service.

It will be appreciated that all traffic-light and percentage scores given in the present description are purely for the purposes of explanation and are non-binding.

### Factors

### i. Arrangement / dependency of elements

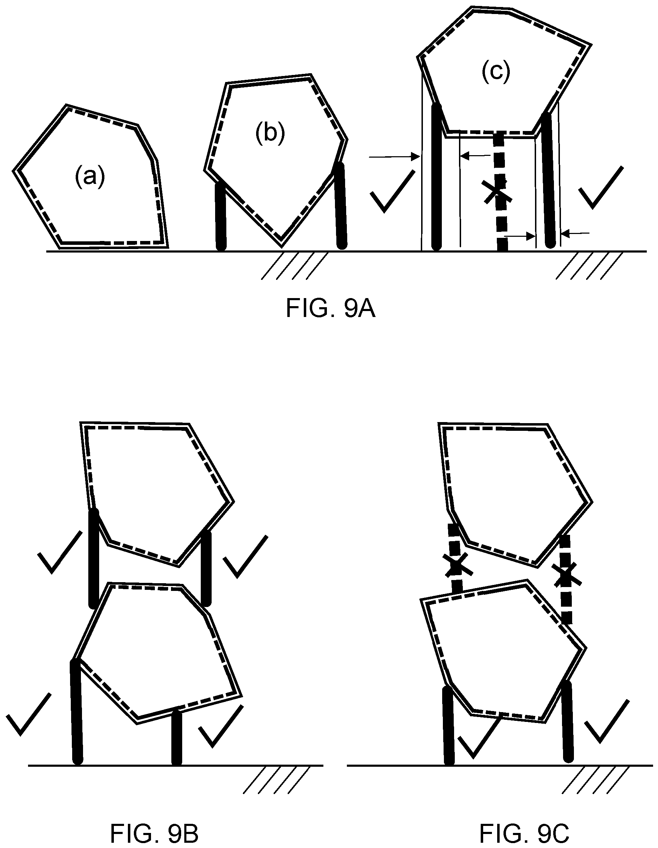

Figures 9A-C illustrate different poses of objects or elements of a compound object (such as blob-man described previously) illustrating difference scenarios where variously an object is self-supporting in the originally captured pose / orientation, and further where it is or is not possible to provide supports if the object is not self-supporting in the captured pose / orientation.

In these figures, 'keep off' areas are denoted by dashed lines internal to the circumference of the object, whilst potentially allowable areas for adding support structures are denoted by internal solid lines. It will be understood that 'keep off' areas are optional, as described previously.

Figure 9A(a) illustrates an object that is self-supporting in the desired pose; this may be calculated for example by determining if the centre of gravity of the object can be made to be above the area bounded by the existing supporting surface of the object. This could get a green indication or a maximum arrangement score (as a non-limiting example, a score of 100%), so no modifications are required at all.

Figures 9A(b) and 9A(c) illustrate an object that is not self-supporting in the desired pose, but can be supported using supports either as specified by the designers or as allowed outside of 'keep off' areas, or simply as calculated heuristically at any feasible position (or any combination of these). Again this may be calculated for example by determining if the centre of gravity of the object can be made to be above the area bounded by the combined supports of the object. This could get a green indication or, reflecting the need for support structures, a high but non-maximum arrangement score (as a non-limiting example, a score of 90%).

Figure 9B illustrates two objects, where one of the objects is dependent upon the other for support (an example of this given previously may be blob-man's torso or hands). In this case, the indicated or allowed areas for support structures between the objects are suitable for the coupling of the objects such that their combined centre of gravity is supportable by support structures (innate or added) of the lower object. Again this could get a green indication or, reflecting the need for more support structures than the case of 9A (a) or (b), a high but non maximum arrangement score (as a non-limiting example, a score of 80%).

Figure 9C illustrates two objects where again one of the objects is dependent upon the other for support, but in this case the indicated or allowed areas for support structures of one or both objects are not able to provide support for the upper object. In this case, the arrangement could receive a yellow light and/or lower score if the situation is salvageable; for example, if the lower object could be rotated to the orientation shown in Figure 9B, then the object above could be supported. In this case, an arrangement score of, for example, 50% may be awarded. However, if this is not possible (for example because the lower object could not be rotated to a position where it in turn could be supported, or because rotation of the object is restricted for other reasons) then the arrangement could receive a red light and/or an arrangement score of e.g. 10%. It will be appreciated that other options and scores ay be considered by the skilled person; for example, violation of a 'keep off' region or replacement of one of the objects with a predetermined alternative may result in a score of 25%.

It will also be appreciated that rather than giving scores in this manner, a total 'ideal' score may have points / percentages deducted for different issues, such as each need to use a keep off area, or a need to rotate a body, and the like, to arrive at an indicative score.

Green, yellow and red thresholds may then be defined to indicate the likely acceptability to the user of the resulting model.

### ii. Connective structures

The thickness, length and number of supporting structures, and/or the extent of modification of a cross-sectional area of an object (as described previously herein) may be similarly scored. For example, starting with a theoretical connection score of 100% for a model with no supporting structures required, a predetermined number of percentage points may be deducted for each support structure or modification of cross-section, and further points may be deducted for any support structure or cross-sectional widening whose thickness exceeds a predetermined absolute or relative value. Alternatively or in addition, percentage points may be deducted responsive to the proportion of the total model that is made up of support structures, whether by calculated external volume or by calculated weight.

Green, yellow and red thresholds may then be defined to indicate the likely acceptability to the user of the number and/or size of connective structures and/or modified elements of the model.

### iii. Data Quality

To a first approximation, high and medium quality data sets may provide quality scores in a 'green light' range, since they typically comprise sufficient materials to reconstruct a scene or character at a given moment in time. The quality score may be lower if the user attempts to select elements of the scene for which data is not available.

Meanwhile low quality data sets may provide quality scores in a 'yellow light' range, since they typically only record predetermined states for characters that may be only an approximation of the character's appearance in the game at that moment. However, for some games (for example games where the low quality data is able to uniquely identify predefined animation poses of a character for a given moment of time, for example), this may be deemed accurate and so the quality score may be in the green range.

### iv. Model Basis

Where a scene or character can be generated using developer provided supplementary printer geometry, this may be given a high or maximum model basis score (as a non-limiting example, a score of 100%).

Where a scene or character can be generated using procedural supplementary geometry (e.g. using rules for generating and/or positioning connective structures between objects, thickening object walls or pruning small/thin objects out of a scene) this may also be given a high or maximum model basis score (as a non-limiting example, a score of 100%). It is likely that if a procedurally generated model is less optimal than one that could have been generated using developer provided supplementary printer geometry, this will be reflected in the arrangement or connective scores discussed previously.

Optionally, the model can be generated as a test, and any errors or failure reported by the procedural generation process may be used to adjust the model basis score downwards.

Where a scene or character can be derived from a collection of images, this may be given a medium model basis score (e.g. in a 'yellow' range). The score may be reduced further in dependence upon the lowest image resolution in the collection of images, which can directly impact the fidelity of the resulting model. Similarly the score may be reduced as a function of variance in colour between corresponding views of an object, which may occur due to changes of in-game lighting between taken images, and which can result in a degradation of colour fidelity.

Optionally, the model can be generated as a test, and any discontinuities or occluded areas of the model may be detected and similarly used to reduce the model basis score.

### v. Printer Status

The type of printer can have a significant effect on what is printable and how. For example, a selective laser sintering printer can print elements of a model that are not initially connected to other parts of the model, but are supported by the surrounding power matrix until a connective structure is formed. By contrast, a fused deposition modelling printer may require contiguous voxels for successive layers of the model so that they can be supported in free space.

These considerations will be reflected in the availability of developer provided supplementary printer geometry supporting different printing schemes, the rules employed and hence results achieved from procedural model generation, and optionally the definition of 'keep off' zones on a model. Hence models of the same character in the same pose may have different connective structures and other changes in appearance because of the printer technology used.

Similarly the material used by the printer may affect the model, typically in terms of the thickness of object walls required for robustness, and the thickness of connective structures as a function of thickness/strength ratio and also any changes in supported mass caused by differences in wall thickness and the like noted above.

Typically selective laser sintering would receive a maximum printer score, whilst fused deposition modelling would receive a lower printer score.

Optionally a model using the constraints set by the printer can be generated as a test. The impact of these constraints will be reflected in other scores mentioned herein, such as in the arrangement or connective scores, and whether or not compatible developer sourced geometry is available.

A score could be modified according to the amount of time the model will take to build (for example reducing a score by N percent for each hour over a predetermined preferable time), and/or according to how much raw material will need to be used.

Finally, if the scene / character is too large to be printed this could result in a 'red' light range printer score.

Each of the arrangement score, connection score, quality score, model basis score and printer scores could be indicated for a particular selected moment from the game. Clearly, where the printer type is not known at the time of score calculation then the printer score can be omitted (for example when pre-computing scores at a server).

More generally any of the above scores can be omitted by designer choice, as long as at least one score remains represented.

### Combined Score

As noted previously, the one score that is represented during gameplay or a review of gameplay may be a combined score derived from some or all of the arrangement, connection, quality, model basis, and printer scores.

This combined score may be weighted according to the relative importance of the contributing scores. For example, the arrangement and connection scores may be more significant than the quality and model basis scores, since a faithful reproduction with well positioned connections may be considered more important than the average voxel resolution of the model, or the time taken to print. The weightings may be chosen by a designer or by a user via an interface.

The combined score may be presented using the traffic light scheme noted previously, or as a percentage, or by any suitable means, such as a star rating out of 5 or 10. Optionally, if the combined score is presented by default, a user can interrogate the system to obtain the underlying scores used to generate the combined score for a given moment in time.

Hence a combined score or the or each individual score may be provided to indicate the printability of a game scene at a given moment. As will be understood from the description previously herein, the 'scene' may be a region of the environment captured in the direction of view of a virtual camera, or it may be a particular user avatar or non-player character or potentially any particular object identified by the user via a suitable user interface. Potentially different scores may be determined for different elements of the environment such as for example the user's avatar and a predetermined non-player character, such as a so-called 'boss'.

### Usage

A combined score or the or each individual score may be provided as an overlay, subtitle, surtitle or other accompanying graphical or textual display on or adjacent to the visual representation of the game, as presented by the game itself (for example when the game is paused, and/or in response to selection of an option to display such information during gameplay if processing resources allow) or as presented by reconstruction of the game state by the videogame console or another device such as a server, or as presented by recorded video images of the game.

A function of the combined score or the each individual score is to provide the user with a rapid assimilation of the printability of the scene at a given moment. Hence for example when reviewing a recording or reconstruction of the game, percentages, the traffic light signals or other indicators may fluctuate from frame to frame, indicating when printing conditions are good, adequate or poor. Where different scores have been calculated for different elements of the environment, these traffic lights or other indicators may track the individual objects or have some other visual association such the pointer or line so that the user can see when a particular character or other in game element is printable.

When a particular moment in time is selected, optionally more details may be provided for example where only a combined score has been shown, individual scores may now be shown instead of or in addition to the combined score.

This allows the user to easily assimilate the fitness of a videogame character / in-game element / scene for 3-D printing, which a user could not do by visual inspection alone simply because the character/element/scene has to be adapted from that which is shown on screen before it can be 3-D printed.

Alternatively or in addition, the combined score or the or each individual score may be used to modify the behaviour of the printing system when the user indicates either they wish to print a character/in game element/scene, or otherwise take the process a step further for example by requesting the generation of a high resolution 3D-printing compatible model for reviewing, editing, or eventually printing, which may take the user's videogame console or a service provider's server considerable time and computing resources to obtain.

In such cases, an overall green range score may cause the relevant device to proceed with the subsequent step in the model generation/print process.

Meanwhile a yellow range score may cause the relevant device to alert the user to potential problems attempting to print the desired object (videogame character / in-game element / scene etc). In particular, any individual score with a yellow range score may be highlighted to assist the user with understanding where problems may lie. In these circumstances, the user may be given the option to override and proceed anyway, and/or they may be given the option to transfer the object to an editing tool where they can change features of the object and have the combined score and/or the or each individual score reassessed in response to their edits.

By contrast, a red range score may cause the relevant device to inform the user that they cannot currently print the desired object. In particular, any individual score with a read range score may be highlighted to assist the user with understanding where problems may lie. In the circumstances, the user may not be given the option to override and proceed anyway, and/or they may be given the option to transfer the object to an editing tool where they can change features of the object and have the combined score and/or the or each individual score reassessed in response to their edits.

It will be understood that references to green ranges, yellow ranges and red ranges represent a shorthand for different value ranges for a given score. It will be appreciated that different value ranges may correspond to green, yellow and red for different scores and for the combined score.

It will also be appreciated that instead of three classifications, only two may be provided for one or more different scores and/or the combined score, for example corresponding to a 'recommend proceed' versus 'recommend do not proceed' evaluation. Conversely, more than three classifications may be provided for one or more different scores and/or the combined score, for example if more options for review, editing and repair are desired. For example, the red range may comprise two ranges, one where the object is transferred to an editing tool, and one where the score is so low that the object is not transferred to the editing tool because the chance of recovering a printable object is so low. Alternatively or in addition, a predetermined score range may prompt an offer to the user to have the object sent to a professional editor who may be able to produce a better result for the user.

### Summary Embodiments

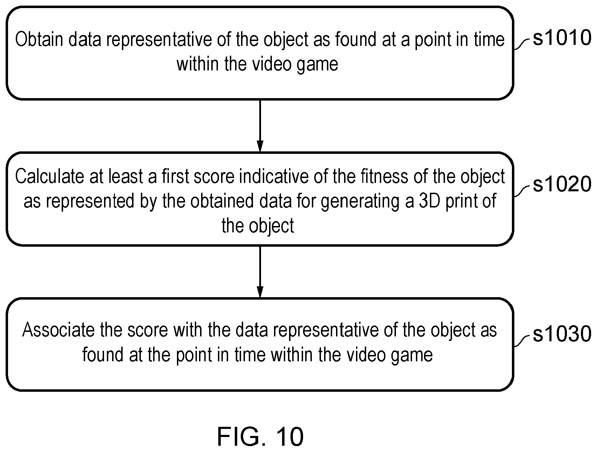

In light of the above disclosures, and referring to Figure 10, in a first summary embodiment of the present invention, a method of calculating the suitability of an object (such as a player avatar, non-player character or the like, as described previously) from a videogame for 3D printing comprises a first step s1010 of obtaining data representative of the object as found at a point in time within the video game

(such as the current game-state within the entertainment device, high medium or low quality sets of values, or sequences of images etc., and described previously); a second step s1020 calculating at least a first score indicative of the fitness of the object as represented by the obtained data for generating a 3D print of the object (for example, in terms of the resulting quality, accuracy, parsimonious use of additional structural features and their placement, and the like, as discussed previously herein); wherein the at least first score is responsive to one or more selected from the list consisting of: the arrangement of the object as found at the point in time within the video game; the dependency of one or more elements of the object upon another element; a property of any connective structure used to connect elements of the 3D printed object together; the quality of the obtained data; and the method used to generate print data used for the 3D printed version of the object (each of these having been discussed previously herein), and a third step s1030 of associating the score with the data representative of the object as found at the point in time within the video game (thereby enabling its immediate or subsequent use for example as a graphical overlay on the paused game or an equivalent visual reconstruction of at least the object of interest).

In an instance of this embodiment, the step of obtaining data representative of the object as found at a point in time within the video game comprises periodically rendering a virtual environment of a videogame for display at a succession of points in time (such as for example at the frame rate of the videogame); periodically recording information that enables a visual reconstruction of at least part of the rendered virtual environment at a succession of points in time (such as for example compressed or uncompressed video images, or game-specific data enabling a reconstruction of the displayed game - if this feature is available within the game); and periodically recording a predetermined set of values responsive to the state of at least part of the rendered virtual environment at a succession of points in time, the predetermined set of values enabling a model of a selected at least part of the rendered virtual environment to be generated that is configured for 3D printing. As described herein, such periodically recorded predetermined sets of values may have different levels of quality, these levels of quality may be interleaved in any suitable order during a recording sequence, and the set of values may require access to videogame assets either as part of a locally hosted game or accessed via a remote server, in order to enable the generation of a model for 3D printing, for example based upon the techniques described previously herein.

In an instance of this embodiment, for the arrangement of the object as found at the point in time within the video game, the at least first score is responsive to a calculation of whether or not the object is self-supporting in the arrangement, as described previously herein. Where it is not self supporting, the first score may be responsive to a calculation of how many support structures are needed to support the object in the arrangement.

In an instance of this embodiment, for the dependency of one or more elements of the object upon another element, the at least first score is responsive to a calculation of whether connective structures required to support the or each dependent element can be anchored to the elements outside areas of exclusion on the elements.

In an instance of this embodiment, for a property of any connective structure used to connect elements of the 3D printed object together, the at least first score is responsive to a calculation of one or more selected from the list consisting of the number of connective structures; the total mass of connective structures; and the mean or maximum length of connective structure.

In an instance of this embodiment, for the quality of the obtained data, the at least first score is responsive to the type of data set obtained (such as the current game-state within the entertainment device, high, medium or low quality sets of values, or sequences of images)

In an instance of this embodiment, for the method used to generate print data used for the 3D printed version of the object, the at least first score is responsive to an analysis of a test generation of the print data. It will be appreciated that the test generation need not be complete (i.e. need not result in a 3D pintable model file). For example, it may run a stage in the generation process comprising accessing supplementary printer geometry provided by the developer. In this case, the score may reflect the extent to which the model can be generated using such supplementary printer geometry, versus other sources of geometry such as procedurally generated geometry. Meanwhile, for a model generated from image data, then as noted previously, the score may be responsive to the average image resolution or the lowest resolution image from which model data is derived.

In an instance of this embodiment, the at least first score is responsive to one or more selected from the list consisting of: the type of 3D printing technology to be used; the type of material from which the 3D printed object is to be made; the amount of material from which the 3D printed object is to be made; and the time required to 3D print the object, as discussed previously herein.

In an instance of this embodiment, as described previously herein a combined score is calculated when a plurality of different scores are calculated for the object as found at a point in time within the video game. Hence if first scores for different aspects / factors of the model have been calculated (such as two or more of the arrangement of the object as found at the point in time within the video game; the dependency of one or more elements of the object upon another element; a property of any connective structure used to connect elements of the 3D printed object together; the quality of the obtained data; and the method used to generate print data used for the 3D printed version of the object), these may be combined to form a combined score, optionally using a weighted combination, as discussed previously.

In this case, an indication of the combined score or the at least first score may be displayed together with a visual representation of the object as found at a point in time within the video game. As noted previously, the visual representation may be the current game display, or a visual reconstruction thereof, depending on the implementation. It will be appreciated that where only the or each first score is displayed, the generation of a combined score may not be necessary.

Finally in an instance of this embodiment, a 3D printing process may be interrupted in response to the combined score or the at least first score. As noted previously, individual and/or combined yellow-range scores may result in a 3D printing process being paused; in this case a selected object may be diverted to an editing program that attempts to overcome deficiencies in the object automatically or alternatively or in addition allows the user to do so. Optionally interruption based on a yellow-range score may be overridden. Meanwhile individual and/or combined red-range scores may result in a 3D printing process being paused, and again optionally, the object may be diverted to an editing program that attempts to overcome deficiencies in the object automatically or alternatively or in addition allows the user to do so. Optionally interruption based on a red-range score may be overridden. The diversion to an editing program may occur at any suitable stage of the 3D print data generation (e.g. altering the original game model, or altering supplementary geometry), and may occur more than once during the generation process, depending on the nature of the identified deficiency or deficiencies.

It will be appreciated that the above methods may be carried out on conventional hardware suitably adapted as applicable by software instruction or by the inclusion or substitution of dedicated hardware.

Thus the required adaptation to existing parts of a conventional equivalent device may be implemented in the form of a computer program product comprising processor implementable instructions stored on a tangible non-transitory machine-readable medium such as a floppy disk, optical disk, hard disk, PROM, RAM, flash memory or any combination of these or other storage media, or realised in hardware as an ASIC (application specific integrated circuit) or an FPGA (field programmable gate array) or other configurable circuit suitable to use in adapting the conventional equivalent device. Separately, such a computer program may be transmitted via data signals on a network such as an Ethernet, a wireless network, the Internet, or any combination of these of other networks.

In another summary embodiment of the present invention, a 3D printing analyser is disclosed for calculating the suitability of an object from a videogame for 3D printing. The analyser may for example be a dedicated hardware device, or a server or an entertainment device such as the PlayStation 4 implementing a set of suitable software instructions. In any case, the 3D printing analyser comprises a memory (such as RAM 22 and/or HDD 37) arranged in operation to store data representative of the object as found at a point in time within the video game; a processor (such as APU 20) arranged in operation to calculate at least a first score indicative of the fitness of the object as represented by the obtained data for generating a 3D print of the object, wherein the at least first score is responsive to one or more selected from the list consisting of: the arrangement of the object as found at the point in time within the video game; the dependency of one or more elements of the object upon another element; a property of any connective structure used to connect elements of the 3D printed object together; the quality of the obtained data; and the method used to generate print data used for the 3D printed version of the object (each of these having been discussed previously herein), and the processor being further adapted in operation to associate the score with the data representative of the object as found at the point in time within the video game.

In an instance of this summary embodiment, the processor is operable to calculate a combined score when a plurality of different scores are calculated for the object as found at a point in time within the video game. Hence, and as noted previously, if first scores for different aspects / factors of the model have been calculated (such as two or more of the arrangement of the object as found at the point in time within the video game; the dependency of one or more elements of the object upon another element; a property of any connective structure used to connect elements of the 3D printed object together; the quality of the obtained data; and the method used to generate print data used for the 3D printed version of the object), these may be combined by the processor to form a combined score, optionally using a weighted combination predetermined by the system or set/adjusted by the user, as discussed previously.

Finally, in an instance of this summary embodiment, the processor is operable to interrupt a 3D printing process in response to the combined score or the at least first score. As noted previously, individual and/or combined yellow-range scores may result in a 3D printing process being paused; in this case a selected object may be diverted to an editing program that attempts to overcome deficiencies in the object automatically or alternatively or in addition allows the user to do so. Optionally interruption based on a yellow-range score may be overridden. Meanwhile individual and/or combined red-range scores may result in a 3D printing process being paused, and again optionally, the object may be diverted to an editing program that attempts to overcome deficiencies in the object automatically or alternatively or in addition allows the user to do so. Optionally interruption based on a red-range score may be overridden. The diversion to an editing program may occur at any suitable stage of the 3D print data generation (e.g. altering the original game model, or altering supplementary geometry), and may occur more than once during the generation process, depending on the nature of the identified deficiency or deficiencies.

## Claims

1. A method of calculating the suitability of an object from a videogame for 3D printing, the method comprising the steps of:
obtaining (s1010) data representative of the object as found at a point in time within the video game;
calculating (s1020) a plurality of different scores indicative of the fitness of the object as represented by the obtained data for generating a 3D print of the object,
wherein the plurality of different scores are respectively responsive to one or more selected from the list consisting of:
i. the arrangement of the object as found at the point in time within the video game;
ii. the dependency of one or more elements of the object upon another element;
iii. a property of any connective structure used to connect elements of the 3D printed object together;
iv. the quality of the obtained data; and
v. the method used to generate print data used for the 3D printed version of the object;
calculating a combined score from the plurality of different scores for the object as found at a point in time within the video game; and
associating (s1030) the combined score with the data representative of the object as found at the point in time within the video game; and
in which an indication of the combined score is displayed together with a visual representation of the object as found at a point in time within the video game.

2. The method of claim 1, in which the step of obtaining data representative of the object as found at a point in time within the video game comprises:
periodically rendering (s810) a virtual environment of a videogame for display at a succession of points in time;
periodically recording (s820) information that enables a visual reconstruction of at least part of the rendered virtual environment at a succession of points in time; and
periodically recording (s830) a predetermined set of values responsive to the state of at least part of the rendered virtual environment at a succession of points in time, the predetermined set of values enabling a model of a selected at least part of the rendered virtual environment to be generated that is configured for 3D printing.

3. The method of claim 1 or claim 2, in which for the arrangement of the object as found at the point in time within the video game, at least a first score is responsive to a calculation of whether or not the object is self-supporting in the arrangement.

4. The method of claim 3, in which the first score is responsive to a calculation of how many support structures are needed to support the object in the arrangement.

5. The method of any one of the preceding claims, in which for the dependency of one or more elements of the object upon another element, at least a first score is responsive to a calculation of whether connective structures required to support the or each dependent element can be anchored to the elements outside areas of exclusion on the elements.

6. The method of any one of the preceding claims, in which for a property of any connective structure used to connect elements of the 3D printed object together, at least a first score is responsive to a calculation of one or more selected from the list consisting of:
i. the number of connective structures;
ii. the total mass of connective structures; and
iii. the mean or maximum length of connective structure.

7. The method of any one of the preceding claims, in which for the quality of the obtained data, at least a first score is responsive to the type of data set obtained.

8. The method of any one of the preceding claims, in which for the method used to generate print data used for the 3D printed version of the object, at least a first score is responsive to an analysis of a test generation of the print data.

9. The method of any one of the preceding claims, in which at least a first score is responsive to one or more selected from the list consisting of:
i. the type of 3D printing technology to be used;
ii. the type of material from which the 3D printed object is to be made;
iii. the amount of material from which the 3D printed object is to be made; and
iv. the time required to 3D print the object.

10. The method of any one of the preceding claims, in which a 3D printing process is interrupted in response to the combined score.

11. A non-transitory computer program product comprising program instructions that, when implemented on a computer, cause the computer to implement the steps of any one of the preceding claims.

12. A 3D printing analyser (10) for calculating the suitability of an object from a videogame for 3D printing, the analyser comprising:
a memory (22, 37) arranged in operation to store data representative of the object as found at a point in time within the video game;
a processor (20) arranged in operation to calculate a plurality of different scores indicative of the fitness of the object as represented by the obtained data for generating a 3D print of the object,
wherein the plurality of different scores are respectively responsive to one or more selected from the list consisting of:
i. the arrangement of the object as found at the point in time within the video game;
ii. the dependency of one or more elements of the object upon another element;
iii. a property of any connective structure used to connect elements of the 3D printed object together;
iv. the quality of the obtained data; and
v. the method used to generate print data used for the 3D printed version of the object;
the processor being further adapted to calculate a combined score from the plurality of different scores for the object as found at a point in time within the video game; and
the processor being further adapted in operation to associate the combined score with the data representative of the object as found at the point in time within the video game; and
in which an indication of the combined score is displayed together with a visual representation of the object as found at a point in time within the video game.

13. The 3D printing analyser of claim 12, in which the processor is operable to interrupt a 3D printing process in response to the combined score or the at least first score.

14. An entertainment device comprising the 3D printing analyser of any one of claims 12-13.

15. A server comprising the 3D printing analyser of any one of claims 12-14.

## Patentansprüche

1. Verfahren zum Berechnen der Eignung eines Objekts aus einem Videospiel zum 3D-Drucken, wobei das Verfahren die folgenden Schritte umfasst:
Erhalten (s1010) von Daten, die für das Objekt, wie zu einem Zeitpunkt im Videospiel gefunden, repräsentativ sind;
Berechnen (s1020) einer Vielzahl von verschiedenen Bewertungen, die die Tauglichkeit des Objekts, wie durch die erhaltenen Daten repräsentiert, zum Erzeugen eines 3D-Drucks des Objekts anzeigen,
wobei die Vielzahl von verschiedenen Bewertungen jeweils in Reaktion auf eines oder mehrere erfolgen, das/die aus der Liste ausgewählt ist/sind, die aus Folgendem besteht:
i. der Anordnung des Objekts, wie zu dem Zeitpunkt im Videospiel gefunden;
ii. der Abhängigkeit von einem oder mehreren Elementen des Objekts von einem anderen Element;
iii. einer Eigenschaft einer Verbindungsstruktur, die verwendet wird, um Elemente des 3D-gedruckten Objekts zu verbinden;
iv. der Qualität der erhaltenen Daten und
v. dem Verfahren, das verwendet wird, um Druckdaten zu erzeugen, die für die 3D-gedruckte Version des Objekts verwendet werden;
Berechnen einer kombinierten Bewertung aus der Vielzahl von verschiedenen Bewertungen für das Objekt, wie zu einem Zeitpunkt im Videospiel gefunden; und
Verknüpfen (s1030) der kombinierten Bewertung mit den Daten, die für das Objekt, wie zu dem Zeitpunkt im Videospiel gefunden, repräsentativ sind; und
bei dem eine Angabe der kombinierten Bewertung zusammen mit einer visuellen Repräsentation des Objekts, wie zu einem Zeitpunkt im Videospiel gefunden, angezeigt wird.

2. Verfahren nach Anspruch 1, bei dem der Schritt des Erhaltens von Daten, die für das Objekt, wie zu einem Zeitpunkt im Videospiel gefunden, repräsentativ sind, Folgendes umfasst:
periodisches Rendern (s810) einer virtuellen Umgebung eines Videospiels zur Anzeige zu einer Folge von Zeitpunkten;
periodisches Aufzeichnen (s820) von Informationen, die eine visuelle Rekonstruktion von mindestens einem Teil der gerenderten virtuellen Umgebung zu einer Folge von Zeitpunkten erlauben; und
periodisches Aufzeichnen (s830) eines vorbestimmten Satzes von Werten in Reaktion auf den Zustand von mindestens einem Teil der gerenderten virtuellen Umgebung zu einer Folge von Zeitpunkten, wobei der vorbestimmte Satz von Werten ein Modell von mindestens einem ausgewählten Teil der zu erzeugenden gerenderten virtuellen Umgebung, das zum 3D-Drucken ausgelegt ist, ermöglichen.

3. Verfahren nach Anspruch 1 oder Anspruch 2, bei dem für die Anordnung des Objekts, wie zu dem Zeitpunkt im Videospiel gefunden, mindestens eine erste Bewertung in Reaktion auf eine Berechnung, ob das Objekt in der Anordnung selbsttragend ist oder nicht, erfolgt.

4. Verfahren nach Anspruch 3, bei dem die erste Bewertung in Reaktion auf eine Berechnung, wie viele Stützstrukturen zum Stützen des Objekts in der Anordnung benötigt werden, erfolgt.

5. Verfahren nach einem der vorhergehenden Ansprüche, bei dem für die Abhängigkeit von einem oder mehreren Elementen des Objekts von einem anderen Element mindestens eine erste Bewertung in Reaktion auf eine Berechnung, ob Verbindungsstrukturen, die zum Stützen des oder jedes abhängigen Elements erforderlich sind, außerhalb von Bereichen des Ausschlusses der Elemente an den Elementen verankert werden können, erfolgt.

6. Verfahren nach einem der vorhergehenden Ansprüche, bei dem für eine Eigenschaft einer Verbindungsstruktur, die verwendet wird, um Elemente des 3D-gedruckten Objekts miteinander zu verbinden, mindestens eine erste Bewertung in Reaktion auf eine Berechnung von einem oder mehreren erfolgt, das/die aus der Liste ausgewählt ist/sind, die aus Folgendem besteht:
i. der Anzahl von Verbindungsstrukturen;
ii. der Gesamtmasse von Verbindungsstrukturen und
iii. der mittleren oder maximalen Länge einer Verbindungsstruktur.

7. Verfahren nach einem der vorhergehenden Ansprüche, bei dem für die Qualität der erhaltenen Daten mindestens eine erste Bewertung in Reaktion auf den erhaltenen Typ eines Datensatzes erfolgt.

8. Verfahren nach einem der vorhergehenden Ansprüche, bei dem für das Verfahren, das verwendet wird, um Druckdaten zu erzeugen, die für die 3D-gedruckte Version des Objekts verwendet werden, mindestens eine erste Bewertung in Reaktion auf eine Analyse einer Probeerzeugung der Druckdaten erfolgt.

9. Verfahren nach einem der vorhergehenden Ansprüche, bei dem mindestens eine erste Bewertung in Reaktion auf eines oder mehrere erfolgt, das/die aus der Liste ausgewählt ist/sind, die aus Folgendem besteht:
i. dem Typ von 3D-Drucktechnologie, die zu verwenden ist;
ii. dem Typ von Material, aus dem das 3D-gedruckte Objekt herzustellen ist;
iii. der Menge von Material, aus dem das 3D-gedruckte Objekt herzustellen ist; und
iv. der Zeit, die zum 3D-Drucken des Objekts erforderlich ist.

10. Verfahren nach einem der vorhergehenden Ansprüche, bei dem ein 3D-Druckvorgang in Reaktion auf die kombinierte Bewertung unterbrochen wird.

11. Nichttransitorisches Computerprogrammprodukt, das Programmanweisungen umfasst, die, wenn sie auf einem Computer implementiert werden, den Computer veranlassen, die Schritte nach einem der vorhergehenden Ansprüche zu implementieren.

12. 3D-Druckanalysator (10) zum Berechnen der Eignung eines Objekts aus einem Videospiel zum 3D-Drucken, wobei der Analysator Folgendes umfasst:
einen Speicher (22, 37), der im Betrieb angeordnet ist, Daten zu speichern, die für das Objekt, wie zu einem Zeitpunkt im Videospiel gefunden, repräsentativ sind;
einen Prozessor (20), der im Betrieb angeordnet ist, eine Vielzahl von verschiedenen Bewertungen, die die Tauglichkeit des Objekts, wie durch die erhaltenen Daten repräsentiert, zum Erzeugen eines 3D-Drucks des Objekts anzeigen, zu berechnen,
wobei die Vielzahl von verschiedenen Bewertungen jeweils in Reaktion auf eines oder mehrere erfolgen, das/die aus der Liste ausgewählt ist/sind, die aus Folgendem besteht:
i. der Anordnung des Objekts, wie zu dem Zeitpunkt im Videospiel gefunden;
ii. der Abhängigkeit von einem oder mehreren Elementen des Objekts von einem anderen Element;
iii. einer Eigenschaft einer Verbindungsstruktur, die verwendet wird, um Elemente des 3D-gedruckten Objekts miteinander zu verbinden;
iv. der Qualität der erhaltenen Daten und
v. dem Verfahren, das verwendet wird, um Druckdaten zu erzeugen, die für die 3D-gedruckte Version des Objekts verwendet werden;
wobei der Prozessor ferner angepasst ist, aus der Vielzahl von verschiedenen Bewertungen für das Objekt,
wie zu einem Zeitpunkt im Videospiel gefunden, eine kombinierte Bewertung zu berechnen; und
wobei der Prozessor im Betrieb ferner angepasst ist, die kombinierte Bewertung mit den Daten zu verknüpfen, die für das Objekt, wie zu dem Zeitpunkt im Videospiel gefunden, repräsentativ sind; und
bei dem eine Angabe der kombinierten Bewertung zusammen mit einer visuellen Repräsentation des Objekts, wie zu einem Zeitpunkt im Videospiel gefunden, angezeigt wird.

13. 3D-Druckanalysator nach Anspruch 12, bei dem der Prozessor betreibbar ist, einen 3D-Druckvorgang in Reaktion auf die kombinierte Bewertung der mindestens ersten Bewertung zu unterbrechen.

14. Unterhaltungsvorrichtung, die den 3D-Druckanalysator nach einem der Ansprüche 12-13 umfasst.

15. Server, der den 3D-Druckanalysator nach einem der Ansprüche 12-14 umfasst.

## Revendications

1. Procédé de calcul de l'adéquation d'un objet d'un jeu vidéo à une impression 3D, le procédé comprenant les étapes consistant à :
obtenir (s1010) des données représentatives de l'objet tel qu'il est trouvé à un moment dans le jeu vidéo ;
calculer (s1020) une pluralité de scores différents qui indiquent l'aptitude de l'objet, tel qu'il est représenté par les données obtenues, pour générer une impression 3D de l'objet,
la pluralité de scores différents étant sensibles respectivement à un ou plusieurs critères sélectionnés dans la liste constituée des critères suivants :
i. l'agencement de l'objet tel qu'il est trouvé au moment dans le jeu vidéo ;
ii. la dépendance d'un ou plusieurs éléments de l'objet à un autre élément ;
iii. une propriété d'une quelconque structure connective utilisée pour connecter ensemble des éléments de l'objet imprimé en 3D ;
iv. la qualité des données obtenues ; et
v. la méthode utilisée pour générer des données d'impression utilisées pour la version imprimée en 3D de l'objet ;
calculer un score combiné à partir de la pluralité de scores différents pour l'objet tel qu'il est trouvé à un moment dans le jeu vidéo ; et
associer (s1030) le score combiné aux données représentatives de l'objet tel qu'il est trouvé au moment dans le jeu vidéo ; et
une indication du score combiné étant affichée conjointement avec une représentation visuelle de l'objet tel qu'il est trouvé à un moment dans le jeu vidéo.

2. Procédé selon la revendication 1, dans lequel l'étape d'obtention de données représentatives de l'objet tel qu'il est trouvé à un moment dans le jeu vidéo comprend les étapes consistant à :
restituer périodiquement (s810), à une succession de moments, un environnement virtuel d'un jeu vidéo en vue de son affichage ;
enregistrer périodiquement (s820), à une succession de moments, des informations qui permettent une reconstruction visuelle d'au moins une partie de l'environnement virtuel restitué ; et
enregistrer périodiquement (s830), à une succession de moments, un ensemble prédéterminé de valeurs en réponse à l'état d'au moins une partie de l'environnement virtuel restitué, l'ensemble prédéterminé de valeurs permettant la génération d'un modèle d'au moins une partie sélectionnée de l'environnement virtuel restitué, qui est configuré pour une impression 3D.

3. Procédé selon la revendication 1 ou 2, dans lequel, pour l'agencement de l'objet tel qu'il est trouvé au moment dans le jeu vidéo, au moins un premier score est sensible à un calcul pour déterminer si l'objet est autoportant ou non dans l'agencement.

4. Procédé selon la revendication 3, dans lequel le premier score est sensible à un calcul pour déterminer combien de structures de support sont nécessaires pour supporter l'objet dans l'agencement.

5. Procédé selon l'une quelconque des revendications précédentes, dans lequel, pour la dépendance d'un ou plusieurs éléments de l'objet à un autre élément, au moins un premier score est sensible à un calcul pour déterminer si des structures connectives, requises pour supporter l'élément dépendant ou chaque élément dépendant, peuvent être ancrées aux éléments en dehors de zones d'exclusion sur les éléments.

6. Procédé selon l'une quelconque des revendications précédentes, dans lequel, pour une propriété d'une structure connective quelconque utilisée pour connecter ensemble des éléments de l'objet imprimé en 3D, au moins un premier score est sensible à un calcul d'un ou plusieurs critères dans la liste constituée des critères suivants :
i. le nombre de structures connectives ;
ii. la masse totale des structures connectives ; et
iii. la longueur moyenne ou maximale d'une structure connective.

7. Procédé selon l'une quelconque des revendications précédentes, dans lequel, pour la qualité des données obtenues, au moins un premier score est sensible au type d'ensemble de données obtenu.

8. Procédé selon l'une quelconque des revendications précédentes, dans lequel, pour la méthode utilisée pour générer des données d'impression utilisées pour la version imprimée en 3D de l'objet, au moins un premier score est sensible à une analyse d'une génération de test des données d'impression.

9. Procédé selon l'une quelconque des revendications précédentes, dans lequel au moins un premier score est sensible à un ou plusieurs critères sélectionnés dans la liste constituée des critères suivants :
i. le type de technologie d'impression 3D à utiliser ;
ii. le type de matériau à partir duquel l'objet imprimé en 3D doit être fabriqué ;
iii. la quantité de matériau à partir duquel l'objet imprimé en 3D doit être fabriqué ; et
iv. le temps requis pour imprimer en 3D l'objet.

10. Procédé selon l'une quelconque des revendications précédentes, dans lequel un processus d'impression 3D est interrompu en réponse au score combiné.

11. Produit de programme informatique non temporaire, comprenant des instructions qui, lorsqu'elles sont mises en œuvre sur un ordinateur, amènent l'ordinateur à mettre en œuvre les étapes selon l'une quelconque des revendications précédentes.

12. Analyseur d'impression 3D (10) pour calculer l'adéquation d'un objet d'un jeu vidéo à une impression 3D, l'analyseur comprenant :
une mémoire (22, 37) conçue, en fonctionnement, pour stocker des données représentatives de l'objet tel qu'il est trouvé à un moment dans le jeu vidéo ;
un processeur (20) conçu, en fonctionnement, pour calculer une pluralité de scores différents qui indiquent l'aptitude de l'objet, tel qu'il est représenté par les données obtenues, pour générer une impression 3D de l'objet,
la pluralité de scores différents étant sensibles respectivement à un ou plusieurs critères sélectionnés dans la liste constituée des critères suivants :
i. l'agencement de l'objet tel qu'il est trouvé au moment dans le jeu vidéo ;
ii. la dépendance d'un ou plusieurs éléments de l'objet à un autre élément ;
iii. une propriété d'une quelconque structure connective utilisée pour connecter ensemble des éléments de l'objet imprimé en 3D ;
iv. la qualité des données obtenues ; et
v. la méthode utilisée pour générer des données d'impression utilisées pour la version imprimée en 3D de l'objet ;
le processeur étant en outre conçu pour calculer un score combiné à partir de la pluralité de scores différents pour l'objet tel qu'il est trouvé à un moment dans le jeu vidéo ; et
le processeur étant en outre conçu, en fonctionnement, pour associer le score combiné aux données représentatives de l'objet tel qu'il est trouvé au moment dans le jeu vidéo ; et
une indication du score combiné étant affichée conjointement avec une représentation visuelle de l'objet tel qu'il est trouvé à un moment dans le jeu vidéo.

13. Analyseur d'impression 3D selon la revendication 12, dans lequel le processeur est fonctionnel pour interrompre un processus d'impression 3D en réponse au score combiné ou à l'au moins un premier score.

14. Dispositif de divertissement comprenant l'analyseur d'impression 3D selon l'une quelconque des revendications 12 et 13.

15. Serveur comprenant l'analyseur d'impression 3D selon l'une quelconque des revendications 12 à 14.
